# EUROPEAN PATENT APPLICATION

(11) **EP 1 675 446 A1**
(43) Date of publication of application: **28.06.2006**
(21) Application number: 04792499.8
(22) Date of filing: 15.10.2004
(51) Int. Cl.: H05K 3/46

(54) **MULTI-LAYER CERAMIC SUBSTRATE, METHOD FOR MANUFACTURNG THE SAME AND ELECTRONIC DEVICE USING THE SAME**

(30) Priority: 17.10.2003 JP 2003358007; 24.10.2003 JP 2003364781
(71) Applicant: HITACHI METALS, LTD., Minato-ku, Tokyo 105-8614 (JP)
(72) Inventor: TANEI, Hirayoshi, Konan-ku, Kanagawa 2330015 (JP); UEDA, Itaru, Kumagaya-shi, Saitama 3600846 (JP); ICHIKAWA, Koji, Kita-ku, Saitama-shi, Saitama 3310814 (JP); TSUNEMATSU, Hiroyuki, Kumagaya-shi, Saitama 3600853 (JP); IKEDA, Hatsuo, Tottori-shi, Tottori 6800872 (JP)
(74) Representative: Strehl Schübel-Hopf & Partner
(86) International application number: PCT/JP2004/015282
(87) International publication number: WO 2005/039263

(57) **Abstract**

A multi-layer ceramic substrate having an in-plane shrinkage ratio of 1% or less with 0.1% or less of unevenness, inorganic particles remaining on the external electrodes being 20% or less by mass as a percentage of one or more metals constituting inorganic particles per the total amount of one or more metals constituting the external electrodes and one or more metals constituting the inorganic particles, is produced by (a) preparing a slurry containing ceramic material powder and an organic binder to form low-temperature-sinterable green substrate sheets, (b) laminating the green substrate sheets after forming electrodes thereon, to produce an unsintered multi-layer ceramic substrate, (c) bonding a constraining layer comprising inorganic particles, which are not sintered at the sintering temperature of the unsintered multi-layer ceramic substrate and have an average particle size of 0.3 µm or more, 0.3-4 times that of the ceramic material powder, and an organic binder, to upper and/or lower surfaces of the unsintered multi-layer ceramic substrate having the external electrodes, to form an integral laminate, (d) sintering the laminate, and (e) removing the constraining layer from the sintered laminate.

## Description

### FIELD OF THE INVENTION

The present invention relates to a multi-layer ceramic substrate produced by a no-shrinkage, low-temperature sintering process, and its production method, and an electronic device comprising this multi-layer ceramic substrate for cell phones, information terminals, etc.

### BACKGROUND OF THE INVENTION

Multi-layer ceramic substrates are at present widely used to constitute various electronic parts such as antenna switch modules, PA module substrates, filters, chip antennas and other package parts, etc. in mobile communications terminals such as cell phones, etc.

The multi-layer ceramic substrate is constituted by pluralities of laminated ceramic layers, comprising internal electrodes formed on each ceramic layer, and via-hole electrodes penetrating the ceramic layers for connecting the internal electrodes inside, and external electrodes on the surface. The multi-layer ceramic substrate, onto which semiconductor chips or other chip parts are usually mounted, is mounted onto a motherboard. For more functions, higher denseness and higher performance, wiring electrodes and external electrodes are arranged at high density.

However, ceramics shrink about 10-25% in a sintering step for obtaining the multi-layer ceramic substrate. Because such large sintering shrinkage does not necessarily occur uniformly in the entire multi-layer ceramic substrate, the ceramic substrate suffers warpage and strain. Such warpage and strain not only deteriorate the characteristics of the multi-layer ceramic substrate, but also cause troubles in a mounting operation, hindering the densification of electrodes. Accordingly, it is desired to make a sintering shrinkage ratio 1% or less with reduced shrinkage unevenness, thereby suppressing the warpage to 30 µm or less per a unit length of 50 mm.

Because a low-resistance Ag-based electrode paste has become used recently, the sintering of the multi-layer ceramic substrate is conducted at as low temperatures as about 800-1000°C. Thus, using green sheets of low-temperature co-firable ceramics (LTCC), which can be sintered at temperatures of 1000°C or lower, particularly glass-ceramic green sheets comprising glass powder, ceramic powder such as alumina, mullite, cordierite, etc., an organic binder and a plasticizer, a so-called "no-shrinkage process" for integrally sintering a multi-layer ceramic substrate with substantially no shrinkage in an X-Y plane has become used.

For instance, Japanese Patent 2554415 and Japanese Patent 2617643 (corresponding to U.S. Patents 5254191 and 5085720) disclose a method comprising preparing green substrate sheets composed of a mixture of ceramic powder dispersed in an organic binder and a sinterable inorganic binder (glass component), and a constraining green sheet comprising inorganic particles (alumina, etc.) dispersed in an organic binder, the inorganic particles being not sintered at a temperature of sintering the green substrate sheets, laminating pluralities of green substrate sheets to form an unsintered multi-layer ceramic substrate, attaching the constraining green sheet to an upper and lower surfaces of the unsintered multi-layer ceramic substrate, and then sintering them. According to this method, the sinterable inorganic binder contained in the green substrate sheets migrates into the constraining green sheet layer by 50 µm or less to bond the constraining green sheets to the green substrate sheets, but the constraining green sheet composed of the inorganic particles is not substantially sintered and thus free from shrinkage, so that the green substrate sheets bonded thereto are suppressed from shrinking in an X-Y plane.

Japanese Patent 3335970 proposes the addition of a glass component to a constraining green sheet to increase the bonding force of the constraining green sheet to green substrate sheets more than described in Japanese Patent 2554415.

JP 9-266363 A proposes that a constraining green sheet adhered to green substrate sheets by the action of a glass component oozing from the green substrate sheets is not peeled from the substrate surface, to use it as a substrate surface.

JP 11-354924 A proposes to control the difference in a thermal expansion coefficient between a multi-layer ceramic substrate and a constraining green sheet after sintering within a predetermined range, to peel the constraining green sheet from the multi-layer ceramic substrate by utilizing a thermal stress.

According to the above no-shrinkage process, the constraining green sheet constrains the green substrate sheets, so that the shrinkage of the green substrate sheets in an X-Y plane is suppressed despite shrinkage in a thickness direction. However, as described in Japanese Patent 3335970, attention has been paid mostly so far to how to increase a bonding force between the green substrate sheets and the constraining green sheet. Because the constraining green sheet becomes a porous powdery sheet, from which an organic binder is evaporated, after sintering in the above conventional technologies, it is relatively easily removed, though complete removal is unlikely actually. Accordingly, the multi-layer ceramic substrate should be provided with stabilized surface conditions. For instance, it is necessary to take into consideration influences on external electrodes on upper and lower surfaces of the multi-layer ceramic substrate, influences on metallized layers of Ni and Au formed on the external electrodes after sintering, etc.

The behavior of a glass component contained in the green substrate sheets will be considered here. The glass component is softened as sintering proceeds, oozing to a green substrate sheet surface. An organic binder evaporated from the constraining green sheet leaves pores in the sheet. Thus, fluidized glass penetrates into pores of the constraining green sheet by a capillary phenomenon, etc. The penetrating depth is typically about 50 µm, though it may vary depending on conditions. The penetration of glass acts to strongly bond both green sheets. However, because the external electrodes are put to a state of floating on molten glass oozing onto the green substrate sheet surface, it is sometimes difficult to keep their dimensional precision and mechanical or electrical quality. In addition, the glass component may attach to the external electrode surfaces during a penetration process, resulting in insufficient electric contact and defective plating.

Further, there is a phenomenon that alumina particles, a main component of the constraining green sheet, penetrate into the green substrate sheets while sintering. Though deeply embedded alumina particles may be removed from the multi-layer ceramic substrate by sand blasting or grinding, external electrodes are also removed from the surface, needing an additional step of forming external electrodes again.

As described above, the conventional no-shrinkage processes cannot suitably be used for unsintered multi-layer ceramic substrates on which external electrodes are formed. Accordingly, a constraining layer was conventionally removed from the multi-layer ceramic substrate after sintering, and then another sintering was conducted after the external electrodes were printed.

### OBJECTS OF THE INVENTION

Accordingly, an object of the present invention is to provide a multi-layer ceramic substrate obtained by sintering an unsintered multi-layer ceramic substrate having external electrodes formed on the surface without shrinkage, which has suppressed shrinkage in an X-Y plane, little warpage and strain, no leaching (erosion by solder) of external electrodes, and good platability.

Another object of the present invention is to provide a method for producing a multi-layer ceramic substrate by forming a constraining layer on upper and/or lower surfaces of an unsintered multi-layer ceramic substrate with external electrodes, and sintering the unsintered multi-layer ceramic substrate, with a sufficient constraining force while suppressing adverse effects on the external electrode surfaces.

A further object of the present invention is to provide an electronic device comprising such a multi-layer ceramic substrate.

### DISCLOSURE OF THE INVENTION

The first multi-layer ceramic substrate of the present invention is obtained by laminating low-temperature-sinterable green substrate sheets comprising a ceramic material, forming external electrodes at least on an upper surface of the resultant unsintered multi-layer ceramic substrate, bonding a constraining layer comprising as main components inorganic particles which are not sintered at the sintering temperature of the unsintered multi-layer ceramic substrate to upper and/or lower surfaces of the unsintered multi-layer ceramic substrate having the external electrodes to form an integral laminate, sintering the integral laminate, and then removing the constraining layer, the multi-layer ceramic substrate having an in-plane shrinkage ratio of 1% or less within 0.1 % unevenness, and the inorganic particles remaining on the external electrodes being 20% or less by mass as a percentage of one or more metals constituting the inorganic particles to the total amount of one or more metals constituting the external electrodes and one or more metals constituting the inorganic particles.

The ceramic material preferably comprises as main components 10-60% by mass, calculated as Al₂O₃, of Al, 25-60% by mass, calculated as SiO₂, of Si, 7.5-50% by mass, calculated as SrO, of Sr, and 0-20% by mass, calculated as TiO₂, of Ti in the form of oxides, the total amount of Al₂O₃, SiO₂, SrO and TiO₂ being 100% by mass, the ceramic material being in the form of powder obtained by pulverization after calcining at 700°C to 850°C. The ceramic material preferably comprises as an auxiliary component 0.1-10 parts by mass, calculated as Bi₂O₃, of Bi per 100 parts by mass of the main components. Furthermore, the ceramic material is preferably mixed with a plasticizer and a solvent.

The auxiliary component preferably comprises at least one selected from the group consisting of 0.1-10 parts by mass, calculated as Bi₂O₃, of Bi, 0.1-5 parts by mass, calculated as Na₂O, of Na, 0.1-5 parts by mass, calculated as K₂O, of K, and 0.1-5 parts by mass, calculated as CoO, of Co, and at least one selected from the group consisting of 0.01-5 parts by mass, calculated as CuO, of Cu, 0.01-5 parts by mass, calculated as MnO₂, of Mn, and 0.01-5 parts by mass of Ag, per 100 parts by mass of the main components. The auxiliary component may further comprise 0.01-2 parts by mass, calculated as ZrO₂, of Zr.

The second multi-layer ceramic substrate of the present invention is obtained by laminating low-temperature-sinterable green substrate sheets containing a ceramic material, forming external electrodes at least on an upper surface of the resultant unsintered multi-layer ceramic substrate, bonding a constraining layer comprising as main components inorganic particles which are not sintered at the sintering temperature of the unsintered multi-layer ceramic substrate to upper and/or lower surfaces of the unsintered multi-layer ceramic substrate having the external electrodes to form an integral laminate, sintering the laminate, and then removing the constraining layer, the multi-layer ceramic substrate having a structure comprising a feldspar crystal based on strontium feldspar and an alumina crystal.

The strontium feldspar generally has a composition of SrAl₂Si₂O₈. At least part of the strontium feldspar crystal is preferably hexagonal.

It is preferable that this multi-layer ceramic substrate also has an in-plane shrinkage ratio of 1% or less with 0.1 % or less of unevenness, and that the inorganic particles remaining on the external electrodes are 20% or less by mass as a percentage of one or more metals constituting the inorganic particles to the total of one or more metals constituting the external electrodes and one or more metals constituting the inorganic particles.

The first method of the present invention for producing a multi-layer ceramic substrate comprises the steps of (a) preparing low-temperature-sinterable green substrate sheets from a slurry containing ceramic material powder and an organic binder, (b) laminating the green substrate sheets after forming electrodes thereon, to form an unsintered multi-layer ceramic substrate, (c) bonding a constraining layer comprising inorganic particles which are not sintered at the sintering temperature of the unsintered multi-layer ceramic substrate and an organic binder to upper and/or lower surfaces of the unsintered multi-layer ceramic substrate having the external electrodes, to form an integral laminate, (d) sintering the laminate, and (e) removing the constraining layer from a surface of the sintered laminate, the inorganic particles having an average particle size of 0.3 µm or more, 0.3-4 times the average particle size of the ceramic material powder.

The second method of the present invention for producing a multi-layer ceramic substrate comprises the steps of (a) finely pulverizing a ceramic material comprising 10-60% by mass, calculated as Al₂O₃, of Al, 25-60% by mass, calculated as SiO₂, of Si, 7.5-50% by mass, calculated as SrO, of Sr, and 0-20% by mass, calculated as TiO₂, of Ti as main components, the total amount of Al₂O₃, SiO₂, SrO and TiO₂ being 100% by mass, which is calcined at 700°C to 850°C, (b) preparing low-temperature-sinterable green substrate sheets from a slurry containing the resultant fine powder of the calcined body and an organic binder, (c) laminating the green substrate sheets after forming electrodes thereon, to form an unsintered multi-layer ceramic substrate, (d) bonding a constraining layer comprising inorganic particles which are not sintered at the sintering temperature of the unsintered multi-layer ceramic substrate, and an organic binder, to upper and/or lower surfaces of the unsintered multi-layer ceramic substrate having the external electrodes, to form an integral laminate, (e) sintering the laminate at 800°C to 1000°C, and (f) removing the constraining layer from the laminate.

The green substrate sheets preferably comprise as auxiliary components at least one selected from the group consisting of 0.1-10 parts by mass, calculated as Bi₂O₃, of Bi, 0.1-5 parts by mass, calculated as Na₂O, of Na, 0.1-5 parts by mass, calculated as K₂O, of K, and 0.1-5 parts by mass, calculated as CoO, of Co, and at least one selected from the group consisting of 0.01-5 parts by mass, calculated as CuO, of Cu, 0.01-5 parts by mass, calculated as MnO₂, of Mn, and 0.01-5 parts by mass of Ag, per 100 parts by mass of the main components. The green substrate sheets may further contain 0.01-2 parts by mass, calculated as ZrO₂, of Zr.

In the second method, too, the inorganic particles preferably have an average particle size of 0.3 µm or more, 0.3-4 times the average particle size of fine powder of the calcined ceramic material.

It is preferable in any methods that a constraining green sheet comprising inorganic particles and an organic binder is cast as the constraining layer on a carrier film, and that a carrier film-contacting surface of the constraining green sheet is bonded to upper and/or lower surfaces of the unsintered multi-layer ceramic substrate having the external electrodes.

The constraining layer is preferably as thick as 50 µm or more. It is preferable that a first constraining layer as thick as 10 µm or more is formed by coating, and that the constraining green sheet is overlapped thereon as a second constraining layer, thereby forming a constraining layer having an overall thickness of 50 µm or more.

It is preferable that the unsintered multi-layer ceramic substrate is produced in the form of a substrate assembly which can be divided to pluralities of substrate chips along dividing grooves, and that the constraining layer is formed on upper and/or lower surfaces of the substrate assembly having external electrodes.

The electronic device of the present invention is obtained by mounting the above multi-layer ceramic substrate onto a circuit board.

### BRIEF DESCRIPTION OF THE DRAWINGS

Fig. 1 is a cross-sectional view showing an unsintered multi-layer ceramic substrate in the form of a substrate assembly before a constraining layer is formed;
Fig. 2 is a perspective view showing an upper surface of the unsintered multi-layer ceramic substrate of Fig. 1;
Fig. 3 is a cross-sectional view showing an unsintered multi-layer ceramic substrate after a constraining layer is formed;
Fig. 4 is a cross-sectional view showing a module obtained by mounting chip parts such as semiconductor devices, etc. onto the multi-layer ceramic substrate of the present invention;
Fig. 5 is a cross-sectional view showing one example of a multi-layer ceramic substrate with a cavity;
Fig. 6(a) is a flow chart showing one example of the production steps of the multi-layer ceramic substrate of the present invention;
Fig. 6(b) is a flow chart showing another example of the production steps of the multi-layer ceramic substrate of the present invention;
Fig. 6(c) is a flow chart showing a further example of the production steps of the multi-layer ceramic substrate of the present invention;
Fig. 7 is a graph showing X-ray powder diffraction patterns of a low-temperature-cofirable ceramic material in the form of a mixed powder, a calcined powder and a sintered body;
Fig. 8(a) is a scanning electron photomicrograph showing a calcined body of a low-temperature-cofirable ceramic material;
Fig. 8(b) is a scanning electron photomicrograph showing powder obtained by pulverizing the calcined body of a low-temperature-cofirable ceramic material;
Fig. 9(a) is a graph showing an X-ray diffraction pattern of a multi-layer ceramic substrate sintered at 850°C;
Fig. 9(b) is a graph showing an X-ray diffraction pattern of a multi-layer ceramic substrate sintered at 860°C;
Fig. 9(c) is a graph showing an X-ray diffraction pattern of a multi-layer ceramic substrate sintered at 875°C;
Fig. 10 is a block diagram showing one example of the applications of high-frequency parts comprising the multi-layer ceramic substrate of the present invention; and
Fig. 11 is a schematic perspective view showing a main printed circuit board of a cell phone comprising a high-frequency part comprising the multi-layer ceramic substrate of the present invention.

### DESCRIPTION OF THE PREFERRED EMBODIMENTS

[1] Multi-layer ceramic substrate
   The multi-layer ceramic substrate of the present invention is obtained by forming external electrodes at least on an upper surface of an unsintered multi-layer ceramic substrate obtained by laminating low-temperature-sinterable green substrate sheets containing a ceramic material, bonding a constraining layer comprising as main components inorganic particles which are not sintered at the sintering temperature of the unsintered multi-layer ceramic substrate to upper and/or lower surfaces of the unsintered multi-layer ceramic substrate having the external electrodes to provide an integral laminate, sintering the laminate, and removing the constraining layer. Thus, the multi-layer ceramic substrate of the present invention has an in-plane shrinkage ratio of 1% or less with 0.1 % or less of unevenness, and the inorganic particles remaining on the external electrodes are 20% or less by mass as a percentage of one or more metals constituting the inorganic particles to the total of one or more metals constituting the external electrodes and one or more metals constituting the inorganic particles.

By calcining the low-temperature-sinterable ceramic material, which may be called "low-temperature-cofirable ceramic material" below, other components than Al₂O₃ and TiO₂ are glassified. Small amounts of Al₂O₃ and TiO₂ can be included into the glass. For uniform glassification with SiO₂ as a main component, the composition should be melted at the sintering temperature of 1300°C or higher. An SiO₂ phase remains in a calcined body obtained at 700°C to 850°C, so that a glass phase is non-uniform. Powder obtained by finely pulverizing a calcined body comprising ceramic particles and a glass phase has a structure in which the ceramic particles are partially or totally covered by glass. As compared with a conventional low-temperature-cofirable ceramic material produced by a melting method, which is a mixture of glass particles and ceramic particles, glass in the powder obtained by pulverizing a calcined body used in the present invention is insufficiently glassified and so less flowable. Such calcined body powder exhibits low reactivity with glass component at the time of sintering, so that the glass component is inactive and so in a high-viscosity state in an interface between the unsintered multi-layer ceramic substrate and the constraining layer. In other words, as compared with the sintering behavior of the unsintered multi-layer ceramic substrate composed of a mixture of glass particles and ceramic particles, the glass component has too little fluidity to ooze to a surface in the unsintered multi-layer ceramic substrate formed from powder obtained by finely pulverizing the calcined body. Accordingly, the glass component is never attached to the external electrodes on the multi-layer ceramic substrate. In addition, the reduced fluidity of the glass component prevents inorganic particles such as alumina, etc. from being embedded in the unsintered multi-layer ceramic substrate.

While densification would tend to be difficult in glass-ceramic green sheets formed from a mixture of glass powder and ceramic powder if the glass powder particles are separate from each other, there is a close contact of glass particles in the powder obtained by finely pulverizing the calcined body because the ceramic particles are partially or totally covered by glass, resulting in densification even at a sintering temperature at which softening and fluidization slightly occur.

Low-temperature-cofirable ceramic materials used in the second production method of the present invention can be densified by low-temperature sintering though it does not contain Pb and B. Among the auxiliary components, Bi, Na, K and Co function as sintering aids, which enable sintering at lower temperatures to provide higher dielectric characteristics of a Q value. Cu, Mn and Ag have a function of accelerating crystallization, thereby enabling low-temperature sintering. Lower-temperature sintering suppresses the melting of glass component.

The multi-layer ceramic substrate after sintering has an anorthite crystal structure, in which Ca is substituted by Sr, including strontium feldspar (SrAl₂Si₂O₈). It has been found that a strontium feldspar-based ceramic substrate containing Al₂O₃ crystal particles dispersed like islands has excellent mechanical strength. In addition, when the strontium feldspar is hexagonal, the substrate has further increased strength. Such structure appears to be obtained by using the above low-temperature-cofirable ceramic materials. Even by a no-shrinkage process, sintering at about 850°C or higher causes a strontium feldspar crystal to be deposited from a glass phase of a calcined body constituting green sheets, thereby increasing an apparent viscosity of a glass phase and thus suppressing the glass component from flowing.

Inorganic particles constituting the constraining layer preferably have an average particle size of 0.3 µm or more, 0.3-4 times that of the low-temperature-cofirable ceramic material powder. For instance, when powder for the green substrate sheets has an average particle size of about 1-3 µm, the inorganic particles have an average particle size of 0.3-4 µm. This makes it easy to remove inorganic particles such as alumina, etc. remaining on the surfaces of the external electrodes. A small amount of the remaining inorganic particles do not substantially affect platability, rather improve resistance to erosion by soldering and the strength of electrodes.

When the average particle size of the ceramic material powder is less than 1 µm, particularly less than 0.6 µm, the casting of green substrate sheets is difficult. On the other hand when the average particle size exceeds 3 µm, it is difficult to form as thin green substrate sheets as 20 µm or less. This relation is valid, even in the case of using fine powder obtained by pulverizing the calcined low-temperature-cofirable ceramic material. The average particle size of the powder obtained by pulverizing a calcined body is more preferably 1-3 µm, most preferably 1-1.5 µm.

When the inorganic particles for the constraining layer have an average particle size of less than 0.3 µm, too much binder is needed for a viscosity necessary for printing, namely the filling ratio of inorganic particles is too small, a uniform constraining force cannot be exerted to both flat portions and dividing grooves of the green substrate sheets. When the average particle size of the inorganic particles exceeds 4 µm, a constraining force is weak particularly on the dividing grooves. The more preferred average particle size of the inorganic particles is 0.5-2 µm.

When the constraining layer is as thick as 50 µm or more, the sintering shrinkage of the green substrate sheets in their X-Y planes can preferably be suppressed to 1% or less. When the thickness of the constraining layer is less than 50 µm, it provides an insufficient constraining force, failing to reduce the sintering shrinkage of the green substrate sheets in their X-Y planes. In the case of printing, cracking occurs when the constraining layer is thicker than 500 µm. Accordingly, when the constraining layer is formed by printing, the preferred thickness of the constraining layer is 50-500 µm. On the other hand, in the case of using a constraining layer in the form of a green sheet, there is no particular upper limit in the thickness of the constraining layer.

When the constraining layer is formed by an inorganic composition comprising inorganic particles such as alumina, etc., an organic binder, a plasticizer, a dispersant and a solvent, it is preferable to form a constraining green sheet on a carrier film in a predetermined thickness, and overlap a carrier film-contacting surface of the constraining green sheet to upper and/or lower surfaces of the unsintered multi-layer ceramic substrate having external electrodes. In this case, the constraining layer is sufficiently removed after sintering because of proper adhesion of inorganic particles to the green substrate sheets.

The force of the constraining layer to constrain the green substrate sheets can be controlled by adjusting the thickness of the constraining layer, the material, particle size, particle size distribution and amount of inorganic particles constituting the constraining layer, the surface conditions of the constraining layer, etc.

In the low-temperature-cofirable ceramic material used in the present invention, SiO₂, SrO and auxiliary components are glassified. Al₂O₃ and TiO₂ can be included in glass in small amounts. However, because the above glass component is not completely melted at a calcining temperature of 700-850°C, a calcined body is in the form of a mixture having an incomplete glass phase and ceramic components. Incidentally, when the calcining temperature is lower than 700°C, insufficient glassification occurs. On the other hand, when the calcining temperature exceeds 850°C, the fine pulverization of a calcined body becomes difficult. When such powder obtained by finely pulverizing the calcined body is sintered at 800-1000°C, the glass component acts as sintering accelerators to densify green substrate sheets, and deposits a SrAl₂Si₂O₈ crystal by reaction with Al₂O₃, thereby providing the green substrate sheets with dielectric characteristics such as high Q (1/tanδ). Namely, the sintered substrate has a structure comprising a SrAl₂Si₂O₈ crystal deposited from the glass component, the remainder of an alumina crystal added as a starting material, and the remainder of the glass component, so that the glass component do not substantially penetrate into the constraining layer.

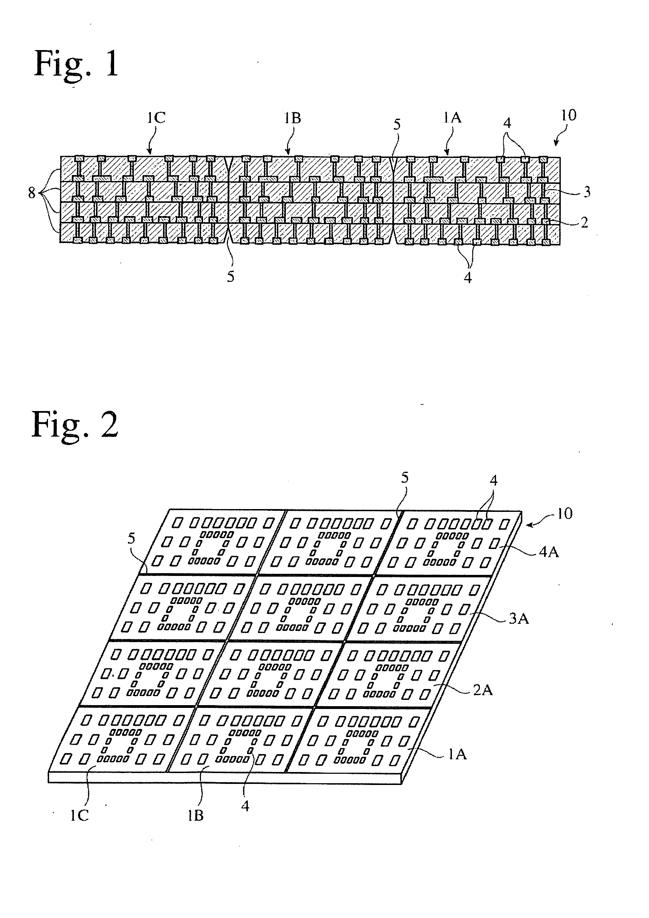

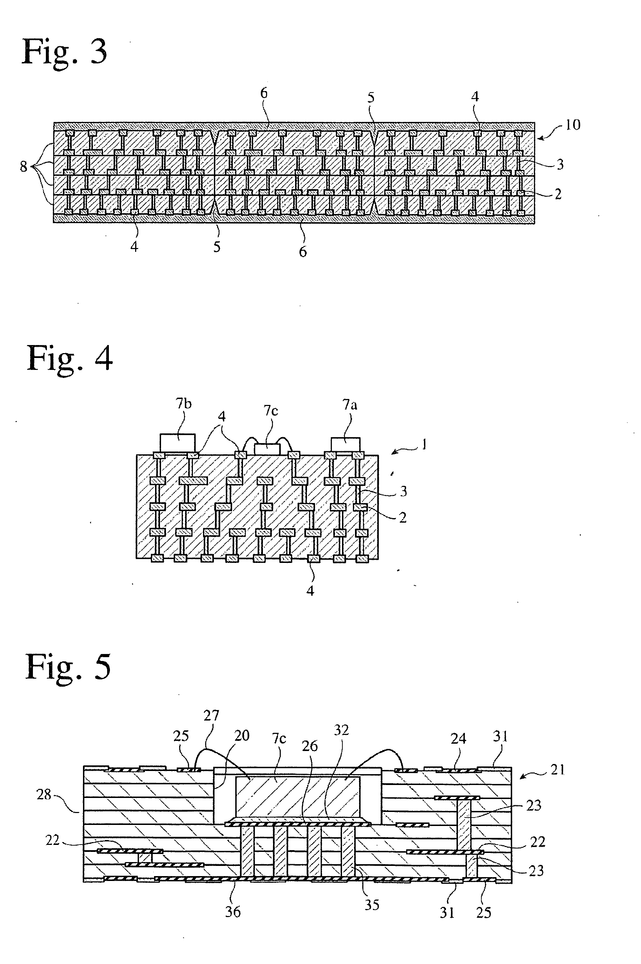

In Fig. 1, the unsintered multi-layer ceramic substrate 10 is obtained by laminating pluralities of green substrate sheets 8, which are printed with an Ag-based paste to form internal electrodes 2. The internal electrodes 2 on each layer are connected through via-electrodes 3 obtained by filling through-holes of the green sheet 8 with a conductor. External electrodes 4 are formed on upper and lower surfaces (and side surfaces, if necessary) of the substrate 10. Though electrodes may be formed on side surfaces to connect the mounted parts to a circuit board, BGA and LGA connections are recently used to connect the via-electrodes 3 to the circuit board by solder balls on a lower surface of the substrate 10. In any case, external electrodes 4 as ground terminals and/or input/output terminals to be connected to the circuit board should be formed on the lower surface of the substrate 10. Formed on the upper surface of the substrate 10 are, as shown in Fig. 4, external electrodes 4 as land electrodes for electrically connecting the internal electrodes 2 to chip parts such as chip capacitors 7a, PIN diodes 7b, semiconductor devices 7c, etc., or external electrodes 4 as wirings for being connected to other devices.

The external electrodes 4 are formed by an Ag-based conductive paste on the unsintered ceramic substrate 10 by a printing method. After sintering, a Ni layer and an Au layer are plated on Ag electrodes to form the land electrodes. Because the arrangement of electrodes in higher densities in the multi-layer ceramic substrate necessitates the external electrodes 4 to be more packed, a slight displacement of the external electrodes 4 may make the connection of the mounted parts impossible. Also, when impurities, etc. are attached to the external electrodes 4, the formation of the Ni layer and the Au layer is difficult, resulting in deficient connection. The existence of such external electrodes 4 affects the flatness of the substrate 10 as well.

Because a multi-layer ceramic substrate is at most several millimeters each in size, it is usual to form a large rectangular substrate assembly of about 100-200 mm in each side, which comprises many multi-layer ceramic substrates as chips, and divide it to individual chips in the final step. Accordingly, the term "multi-layer ceramic substrate" used herein includes not only individual multi-layer ceramic substrates, but also a substrate assembly before dividing.

The constraining layers 6, 6 formed on the upper and/or lower surfaces of the unsintered multi-layer ceramic substrate 10 as shown in Fig. 3 are removed after sintering. After a module substrate 1 is produced by mounting chip parts such as PIN diodes 7b, chip capacitors 7a, etc. onto the upper surface of the multi-layer ceramic substrate, it is divided along dividing grooves 5 to individual multi-layer ceramic substrates. The module substrate 1 is mounted onto the circuit board together with other electronic parts, and this circuit board is used to constitute electronic devices of cell phones, etc.

Fig. 5 shows a multi-layer ceramic substrate 21 having a cavity 20. The substrate 21 obtained by laminating pluralities of green sheets 28 has a cavity 20 on its upper surface, in which a semiconductor device 7c is mounted. Internal electrodes 22 are printed on each green sheet 28, and connected through via-electrodes 23. External electrodes 24 for mounting chip parts and external electrodes 25 as input/output terminals are formed on upper and lower surfaces of the substrate 21. An overcoat layer 31 is properly formed around the external electrodes 24, 25 to prevent a solder from flowing. Formed in the cavity 20 are electrodes 26, on which the semiconductor device 7c is mounted by a solder paste 32, etc. The input/output electrodes of this semiconductor device 7c are connected to terminal electrodes 25 via bonding wires 27. Formed on a lower surface of the cavity 20 are thermal vias 35 extending to a lower surface of the substrate, to which terminals 36 on the lower surface of the substrate are connected. The lower-surface terminals 36 are terminals substantially arranged in a lattice pattern for electrically connecting the substrate 21 to another larger substrate such as a PCB substrate mainly constituting the internal structure of a mobile terminal, etc. The external electrodes formed on the upper and lower surfaces of the substrate 21 are finally provided with a Ni plating, a Au plating, etc.

[2] Production method of multi-layer ceramic substrate
   (A) Materials for green substrate sheets
      The composition of the low-temperature-cofirable ceramic material for forming green substrate sheets comprises, for instance, 10-60% by mass, calculated as Al₂O₃, of Al, 25-60% by mass, calculated as SiO₂, of Si, 7.5-50% by mass, calculated as SrO, of Sr, and 0-20% by mass, calculated as TiO₂, of Ti as main components in the form of oxides, the total amount of Al₂O₃, SiO₂, SrO and TiO₂ being 100% by mass. The low-temperature-cofirable ceramic material may contain 0.1-10 parts by mass, calculated as Bi₂O₃, of Bi as an auxiliary component per 100 parts by mass of the main components. When the low-temperature-cofirable ceramic material is composed only of the main components, the green substrate sheets can be sintered at a temperature of 1000°C or lower. On the other hand, when it contains the auxiliary component, too, the green substrate sheets can be sintered at a temperature of 900°C or lower. Thus, using high-conductivity metals such as silver, copper and gold as conductors for electrodes, the green substrate sheets can be sintered integrally with the electrodes.

The auxiliary components preferably comprise at least one selected from the group consisting of 0.1-10 parts by mass, calculated as Bi₂O₃, of Bi, 0.1-5 parts by mass, calculated as Na₂O, of Na, 0.1-5 parts by mass, calculated as K₂O, of K, and 0.1-5 parts by mass, calculated as CoO, of Co, per 100 parts by mass of the main components. These auxiliary components have a function to lower the softening point of glass obtained by calcining, thereby making it possible to obtain ceramic materials sinterable at lower temperatures. They can also provide the ceramic materials with high dielectric characteristics such as high Q when sintered at temperatures of 1000°C or lower.

The auxiliary components preferably further comprise at least one selected from the group consisting of 0.01-5 parts by mass, calculated as CuO, of Cu, 0.01-5 parts by mass, calculated as MnO₂, of Mn, and 0.01-5 parts by mass of Ag, per 100 parts by mass of the main components. These auxiliary components have a function to accelerate crystallization mainly in a sintering step, thereby achieving low-temperature sintering.

(1) Al: 10-60% by mass (calculated as Al₂O₃)
   When Al is more than 60% by mass calculated as Al₂O₃, sintering at as low temperature as 1000°C or lower fails to increase a sintering density sufficiently, resulting in a porous substrate, which does not have good characteristics because of moisture absorption, etc. When Al is less than 10% by mass calculated as Al₂O₃, the resultant substrate does not have high strength. The more preferred content of Al is 40-55% by mass (calculated as Al₂O₃).

(2) Si: 25-60% by mass (calculated as SiO₂)
   When Si is less than 25% or more than 60% by mass calculated as SiO₂, sintering at as low temperature as 1000°C or lower fails to increase a sintering density sufficiently, resulting in a porous ceramic substrate. The more preferred content of Si is 31-45% by mass (calculated as SiO₂).

(3) Sr: 7.5-50% by mass (calculated as SrO)
   When Sr is less than 7.5% or more than 50% by mass calculated as SrO, sintering at as low temperature as 1000°C or lower fails to increase a sintering density sufficiently, resulting in a porous ceramic substrate. The more preferred content of Sr is 7.5-17.5% by mass (calculated as SrO).

(4) Ti: 0-20% by mass (calculated as TiO₂)
   When Ti is more than 20% by mass as TiO₂, sintering at as low temperature as 1000°C or lower fails to increase a sintering density sufficiently, resulting in a porous substrate. Also, a higher Ti content tends to provide the ceramic with a higher temperature coefficient of a resonance frequency, thereby failing to obtain good characteristics. A ceramic containing no Ti has a temperature coefficient if of a resonance frequency of -20 ppm/°C to -40 ppm/°C, and the τf increases as the Ti content increases. Accordingly, it is easy to control the τf to 0 ppm/°C by the Ti content. The more preferred content of Ti is 0-10% by mass (as TiO₂).

(5) Bi: 0.1-10 parts by mass
   Bi has a function to lower the softening point of glass formed in a calcining step, thereby lowering a sintering temperature. Bi can further provide the ceramic with dielectric characteristics of high Q at the sintering temperature of 1000°C or lower. However, when Bi is more than 10 parts by mass calculated as Bi₂O₃ per 100 parts by mass of the main components, the Q value becomes smaller. Thus, Bi is preferably 10 parts or less by mass, more preferably 5 parts or less by mass. When Bi is less than 0.1 parts by mass, there is substantially no effect of lowering the sintering temperature. Accordingly, Bi is preferably 0.1 parts or more by mass, more preferably 0.2 parts or more by mass.

(6) Na, K and Co: 0.1-5 parts by mass
   When each of Na, K and Co is less than 0.1 parts by mass calculated as Na₂O, K₂O and CoO, respectively, per 100 parts by mass of the main components, there is an insufficient effect of lowering the softening point of glass. On the other hand, when each exceeds 5 parts by mass, a large dielectric loss occurs. Accordingly, each of Na, K and Co is preferably 0.1-5 parts by mass.

(7) Cu and Mn: 0.01-5 parts by mass
   Cu and Mn accelerate the crystallization of dielectric ceramics in a sintering step, thereby achieving low-temperature sintering. When both of Cu and Mn are less than 0.01 parts by mass (calculated as CuO and MnO₂, respectively), there is no sufficient effect, failing to provide the substrate with high Q by sintering at 900°C or lower. When it exceeds 5 parts by mass, the ceramics do not have low-temperature sinterability. Accordingly, each of Cu and Mn is preferably 0.01-5 parts by mass.

(8) Ag: 0.01-5 parts by mass
   Ag can lower the softening point of glass, and accelerate the crystallization of glass, thereby achieving low-temperature sintering. However, when Ag is 0.01 parts by mass, its effect is insufficient. On the other hand, more than 5 parts by mass of Ag leads to too much dielectric loss. Accordingly, Ag is preferably 0.01-5 parts by mass, more preferably 2 parts or less by mass.

(9) Zr: 0.01-2 parts by mass
   The inclusion of 0.0 1-2 parts by mass, calculated as ZrO₂, of Zr further increases the mechanical strength of the substrate.

(10) Pb and B
   The low-temperature-cofirable ceramic material used in the present invention does not contain Pb and B, which are contained in conventional materials. Because PbO is a harmful material, the disposal of wastes containing PbO takes high cost, and the handling of PbO during production processes needs a lot of care. B₂O₃ is disadvantageous in being dissolved in water and alcohol during production processes, segregated at the time of drying, reacted with electrode materials during sintering, and reacted with an organic binder to deteriorate its properties, etc. The low-temperature-cofirable ceramic material used in the present invention is environmentally advantageous because it does not contain such harmful elements devices.

(B) Formation of green substrate sheets
   Powders of the above main components and auxiliary components are wet-mixed in a ball mill. The resultant slurry is dried by heating to evaporate moisture, crushed, and calcined at 700-850°C. The calcining time is preferably 1-3 hours. A calcined body is wet-pulverized for 10-40 hours in a ball mill to produce fine powder having an average particle size of 0.6-2 µm. The fine powder of the calcined body is composed of ceramic particles partially or totally coated with glass.

The organic binder is properly selected to adjust the strength, drillability, press-bondability, dimensional stability, etc. of green sheets. The preferred organic binders are, for instance, a polyvinyl butyral resin and a polymethacrylic resin. The amount of the organic binder added is 5% or more by mass, preferably 10-20% by mass, based on the entire green sheets.

Butylphthalyl butylglycolate (BPBG), di-n-butyl phthalate, etc. are preferably added as a plasticizer, and ethanol, butanol, toluene, isopropyl alcohol, etc. are preferably added as a solvent. These materials are mixed in a ball mill to form a slurry comprising the fine powder of the calcined body. To improve the uniformity of the slurry, a dispersant may effectively be added, if necessary.

After defoaming the slurry under reduced pressure, and partially evaporating the solvent to adjust the viscosity, the slurry is cast to form a sheet on a carrier film by a doctor blade method. From the aspect of mechanical strength, surface flatness, etc., the carrier film is preferably a polyethylene terephthalate (PET) film. The resultant green substrate sheet is cut to a predetermined size together with the carrier film.

(C) Production of unsintered multi-layer ceramic substrate
   After the above green substrate sheets are sufficiently dried, they are provided with via-holes 3, and the via-holes 3 are filled with an Ag-based conductive paste, and further internal electrode patterns 2 are printed on the sheets by an Ag-based conductive paste. Green sheets at the top and lower of the substrate are provided with external electrode patterns 4. These green substrate sheets are laminated and thermally bonded under compression. The thickness of the resultant green sheet laminate is generally 1.0-2.0 mm, though variable depending on targeted modules.

The thermal press-bonding conditions are preferably a temperature of 50-95°C and pressure of 50-200 kg/cm² (4.9-19.6 MPa). The pattern of the external electrodes 4 may be formed after thermal bonding under pressure. Thereafter, as shown in Fig. 2, dividing grooves 5 are formed on the green sheet laminate at such intervals as to provide substrate chips 1A-4A, 1B-4B, 1C-4C (some symbols are shown). Because an inorganic paste for the constraining layer enters into the dividing grooves 5, a large constraining force can be obtained.

(D) Production of constraining paste
   The constraining layer 6 comprises inorganic particles, which are not sintered at the sintering temperature of the unsintered multi-layer ceramic substrate made of a low-temperature-cofirable ceramic material. The inorganic particles are preferably alumina powder, zirconia powder, etc. To control a constraining force, the inorganic particles preferably have an average particle size of 0.3-4 µm. When the average particle size of the inorganic particles is less than 0.3 µm, a large amount of a binder should be used to achieve a viscosity necessary for printing, resulting in a smaller filling ratio of inorganic particles and thus an insufficient constraining force. When the average particle size of the inorganic particles exceeds 4 µm, there is a weak constraining force in the dividing grooves 5. The preferred average particle size of the inorganic particles is 1-4 µm.

The average particle size Dc of the inorganic particles is preferably controlled to 0.3-4 times the average particle size Ds of a ceramic material powder constituting the green substrate sheets and fine powder of the calcined body. Particularly to prevent inorganic particles from remaining on external electrodes on the unsintered multi-layer ceramic substrate, the average particle size Dc of the inorganic particles is preferably equal to or more than the average particle size Ds of the ceramic powder or the fine powder of the calcined body. Specifically, Dc/Ds is preferably 1-4, more preferably 1.5-4.

The organic binder in the constraining layer may not be stricter in selecting conditions than that in the green substrate sheets, and may be smaller in an amount than the latter. The organic binders are preferably cellulose resins, a polymethacrylic resin, etc., which are well thermally decomposable. The plasticizers are preferably butylphthalyl butylglycolate (BPBG), di-n-butyl phthalate, etc. The solvents are preferably alcohols such as ethanol, butanol, isopropyl alcohol and terpineol. When the constraining layer is formed by printing, the amount of the organic binder added is preferably 1.5-4% by mass to have sufficient viscosity necessary for printing, and sufficient adhesion between powder particles in the paste and between the powder particles and the substrate.

(E) Production of constraining green sheet
   When the constraining layer 6 is in the form of a green sheet, a sheet of an inorganic composition containing 8-15 parts by mass of an organic binder and a solvent per 100 parts by mass of inorganic particles is formed on a carrier film by a doctor blade method. 4-8 parts by mass of a plasticizer and a small amount of a dispersant may be added. The inorganic particles, the organic binder, the plasticizer and the solvent are mixed in a ball mill, to form a constraining-sheet-forming slurry.

After the slurry is defoamed under a reduced pressure with a solvent partially evaporated to adjust the viscosity, it is cast to a sheet on a carrier film by a doctor blade method. The resultant constraining green sheet is cut to a predetermined size together with the carrier film.

(F) Formation of constraining layer on unsintered multi-layer ceramic substrate
   To form the constraining layer 6 on upper and/or lower surfaces of the unsintered multi-layer ceramic substrate 10, the following are conducted:
   (a) printing a paste having the above inorganic composition on the unsintered multi-layer ceramic substrate to a desired thickness (if necessary, repeating printing and drying),
   (b) casting an inorganic composition to form a constraining green sheet having a desired thickness in advance, and overlapping it on the unsintered multi-layer ceramic substrate,
   (c) printing a constraining layer on the unsintered multi-layer ceramic substrate, and overlapping a constraining green sheet thereon, or
   (d) combination thereof.

The thickness of the constraining layer is 50 µm or more per one side of the unsintered multi-layer ceramic substrate. When the thickness of the constraining layer is less than 50 µm, there is an insufficient constraining force, failing to sufficiently suppress the sintering shrinkage of the unsintered multi-layer ceramic substrate in an X-Y plane. When the constraining layer is as thick as 50 µm or more, the sintering shrinkage of the unsintered multi-layer ceramic substrate in an X-Y plane can be suppressed to 1% or less. When the constraining layer is in the form of a green sheet, there is no particular upper limit in its thickness. However, when the constraining layer is printed, a printed layer thicker than 500 µm suffers from cracking. Accordingly, a proper thickness for the printed constraining layer is 50-500 µm.

In the case of using a constraining green sheet, it is laminated on upper and/or lower surfaces of the unsintered multi-layer ceramic substrate having external electrodes, such that a surface of the constraining green sheet in contact with a carrier film is bonded to the surface of the unsintered multi-layer ceramic substrate, and press-bonded. When the carrier film-contacting surface of the constraining green sheet is bonded to the unsintered multi-layer ceramic substrate, the constraining layer can be removed extremely easily after sintering. The reasons therefor are presumed as follows. Because the binder in the constraining green sheet is concentrated on the carrier film-contacting surface, there is a large force of constraining the unsintered multi-layer ceramic substrate on the carrier film-contacting surface, with reduced tendency of the inorganic particles to adhere to the unsintered multi-layer ceramic substrate (cushioning function). Accordingly, when the carrier film-contacting surface of the constraining green sheet is bonded to the surface of the unsintered multi-layer ceramic substrate, it is easy to remove the inorganic particles after sintering, while sufficiently keeping a constraining force.

Though there is no theoretical upper limit in the thickness of the constraining green sheet, the production of a thick constraining layer by printing practically needs a lot of printing and drying steps. However, a high-fluidity paste used in the printing method enters into recesses such as dividing grooves, etc. of the unsintered multi-layer ceramic substrate, exerting a high constraining effect. Accordingly, it is preferable to form a first constraining layer having some thickness by a printing method, and then overlap a green sheet having a desired thickness as a second constraining layer thereon. In this case, it is preferable that the first constraining layer as thick as 10 µm or more is formed by printing, and that a constraining green sheet is overlapped thereon to form the second constraining layer, such that the thickness of the resultant constraining layer is 50 µm or more.

The constraining green sheet is thermally press-bonded to the unsintered multi-layer ceramic substrate. The thermal press-bonding conditions of the green substrate sheet to the unsintered multi-layer ceramic substrate are a temperature of 50-95°C and pressure of 50-200 kg/cm² (4.9-19.6 MPa).

(G) Sintering of unsintered multi-layer ceramic substrate with constraining layer
   After removing the binder at 400-650°C for 2-10 hours, it is sintered at 800-1000°C for 1-4 hours. When the sintering temperature is lower than 800°C, the densification of the substrate cannot easily be achieved even by an elongated sintering time. When it exceeds 1000°C, it is difficult to form Ag electrodes, and a multi-layer ceramic substrate having high dielectric characteristics cannot be obtained.

(H) Removal of constraining layer
   After sintering, alumina particles are removed from the surface of the multi-layer ceramic substrate, particularly external electrodes thereon. This is conducted by applying ultrasonic waves to the sintered multi-layer ceramic substrate in water in an ultrasonic washing bath. Though ultrasonic washing removes almost all alumina particles, alumina particles on the external electrodes (for instance, Ag pads) are not necessarily removed completely by ultrasonic washing. Accordingly, sand blasting with impact controlled not to damage the external electrodes is used, if necessary, to remove alumina particles. Sand materials may be alumina, glass, zircon, resin particles, etc. It has been found, however, that even if alumina particles remain to some extent after ultrasonic washing, the substrate has relatively good platability. It has been found that particularly when alumina particles remain at a proper level, the external electrodes of Ag have improved resistance to erosion by soldering.

(I) Mounting of parts and division of substrate assembly
   A Ni plating and a Au plating, etc. are formed on Ag pads, from which alumina particles are removed, by an electroless plating method. After a solder pattern is screen-printed on the external electrodes metallized with Ni and Au, parts such as semiconductor devices, etc. are mounted thereon, and connected by reflow soldering. In the case of wire-bondable semiconductor devices, wire bonding is carried out after reflow soldering. Finally, the substrate assembly is broken along the dividing grooves, to obtain individual multi-layer ceramic substrates.

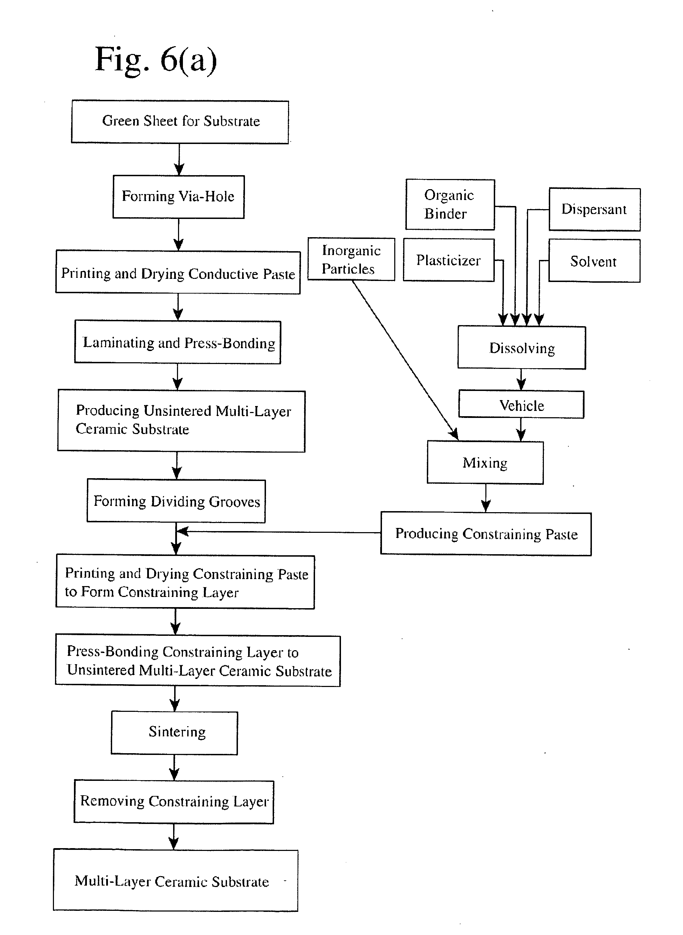

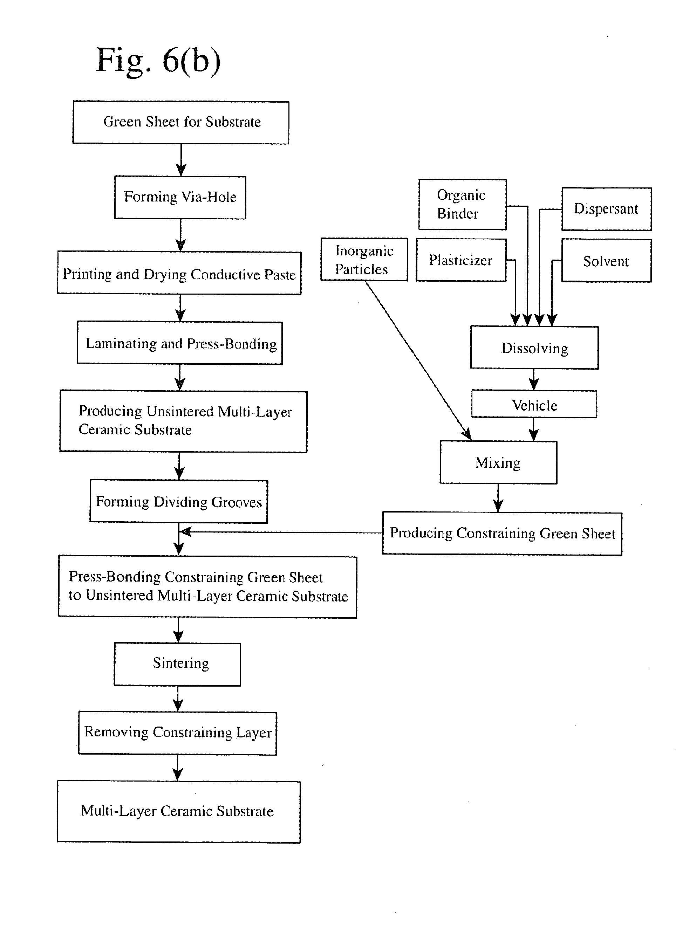

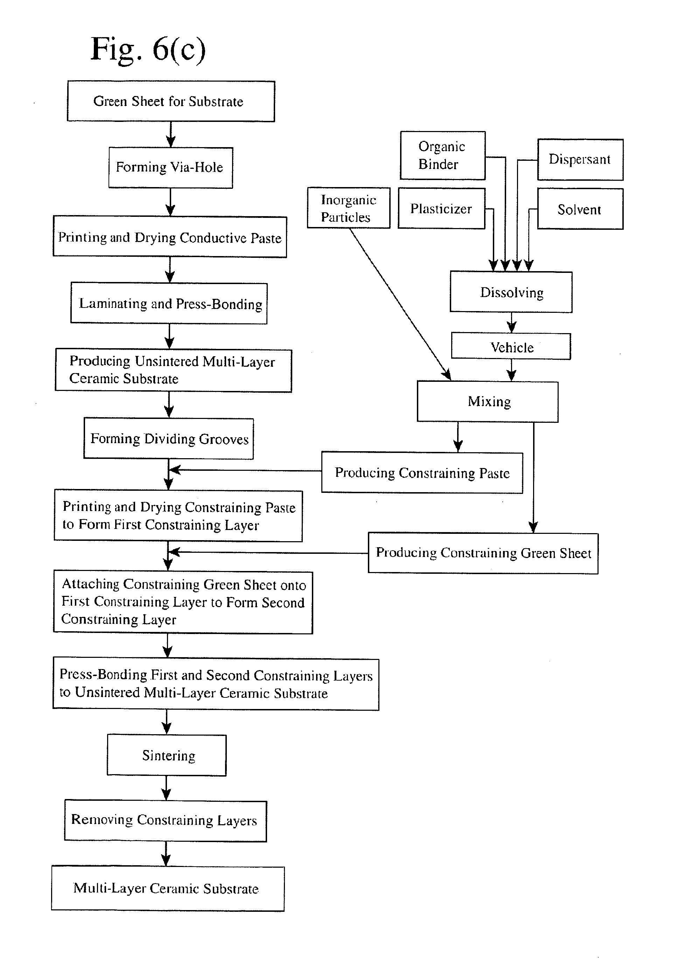

Fig. 6(a) shows the production steps of a multi-layer ceramic substrate, in which a paste of inorganic particles is printed on the unsintered multi-layer ceramic substrate to form a constraining layer, Fig. 6(b) shows the production steps of a multi-layer ceramic substrate, in which a constraining green sheet is laminated on the unsintered multi-layer ceramic substrate to form a constraining layer, and Fig. 6(c) shows the production steps of a multi-layer ceramic substrate, in which a paste of inorganic particles is printed on the unsintered multi-layer ceramic substrate to form a first constraining layer, and a constraining green sheet is then laminated on the unsintered multi-layer ceramic substrate to form a second constraining layer.

The present invention will be explained in further detail referring to Examples below without intention of restricting it thereto.

### Example 1

Using Al₂O₃ powder having a purity of 99.9% and an average particle size of 0.5 µm, SiO₂ powder having a purity of 99.9% or more and an average particle size of 0.5 µm or less, SrCO₃ powder having a purity of 99.9% and an average particle size of 0.5 µm, TiO₂ powder having a purity of 99.9% and an average particle size of 0.5 µm, and Bi₂O₃ powder, Na₂CO₃ powder, K₂CO₃ powder, CuO powder, Ag powder, MnO₂ powder and Co₃O₄ powder each having a purity of 99.9% and an average particle size of 0.5-5 µm, low-temperature-cofirable ceramic materials having compositions shown in Table 1 were produced. Samples without asterisk are within the scope of the present invention, and those with asterisk are outside the present invention (the same will apply hereinafter).

(B) Production of green substrate sheets
   Each mixed powder having the composition shown in Table 1 was charged into a polyethylene ball mill together with zirconium oxide medium balls and pure water, and wet-mixed for 20 hours. The resultant slurry was dried by heating, crushed by an automated mortar, and then calcined at 800°C for 2 hours in an alumina crucible. The resultant calcined body was charged into the above ball mill, wet-pulverized for 17 hours, and dried to obtain fine powder having an average particle size of 1 µm.

100 parts by mass of the fine powder of the calcined body was mixed with 15 parts by mass of a polyvinyl butyral resin as an organic binder, 7.5 parts by mass of butylphthalyl butylglycolate (BPBG) as a plasticizer, and ethanol as a solvent in a ball mill, to produce a slurry. Incidentally, a dispersant was not added.

The slurry was defoamed under reduced pressure, and ethanol was partially evaporated to adjust its viscosity to about 7 Pa·s. The slurry was cast to a sheet on a carrier film of PET by a doctor blade method, and dried to a green substrate sheet as thick as 0.15 mm. The green substrate sheet was cut to squares of 180 mm each together with the carrier film.

After sufficiently drying each green substrate sheet, internal electrode patterns and external electrode patterns were formed by an Ag-based conductive paste. The green substrate sheets with electrodes were press-bonded one by one at a temperature of 60°C and a pressure of 30 kg/cm² (2.8 MPa), and then thermally press-bonded at a temperature of 85°C and a pressure of 110 kg/cm² (10.8 MPa). The resultant unsintered multi-layer ceramic substrate (substrate assembly) was as thick as 1.3 mm.

A knife edge was pressed onto the unsintered multi-layer ceramic substrate (substrate assembly), to form dividing grooves 5 each having an isosceles triangular cross section of 0.15 mm in width and 0.1 mm in depth at intervals of 10 mm x 15 mm.

100 parts by mass of alumina powder having an average particle size of 0.5 µm was mixed with 10.2 parts by mass of a polyvinyl butyral resin as an organic binder, 6.2 parts by mass of BPBG as a plasticizer, and ethanol in a ball mill, to produce a slurry free from dispersant. The slurry was defoamed under a reduced pressure, and the solvent was partially evaporated to adjust its viscosity to about 5 Pa·s. This slurry was cast to a sheet on a carrier film of PET by a doctor blade method, and dried to obtain a constraining green sheet as thick as 0.15 mm. The constraining green sheet was cut to squares of 180 mm each together with the carrier film.

The constraining green sheet was overlapped on upper and lower surfaces of the substrate assembly, such that the carrier film-contacting surface of the constraining green sheet were brought into contact with the substrate assembly surface, and thermally press-bonded at a temperature of 85°C and a pressure of 110 kg/cm² (10.8 MPa) to form an integral laminate.

The laminate was kept at 500°C for 4 hours in a batch-type furnace with an air atmosphere to remove the binder, heated to 900°C at a speed of 3°C/minute, kept at that temperature for 2 hours for sintering, and then spontaneously cooled in the furnace.

Alumina particles were removed from the sintered laminate by ultrasonic washing. Substrate assemblies thus obtained were evaluated by the following methods with respect to a shrinkage ratio in an X-Y plane and its unevenness (deviation), denseness, high-frequency characteristics and the conditions of external electrodes. The evaluation results are shown in Table 1.

(1) Shrinkage ratio in an X-Y plane
   8 chips were selected in total at four corners and at centers of four sides in the substrate assembly before forming a constraining layer, and distances between two diagonal lines of each chip in both X-axis and Y-axis directions were measured by a three-dimensional coordinate-measuring device, to determine X-Y coordinates X₀, Y₀. Likewise, distances between two diagonal lines of each chip in the sintered substrate assembly in both X-axis and Y-axis directions were measured to determine X-Y coordinates Xn, Yn. Xn/X₀ ratios and Yn/Y₀ ratios were averaged over 8 chips (n = 1-8), to determine a sintering shrinkage ratio of the substrate assembly sintered after forming the constraining layer. Deviations of these ratios are defined as unevenness of the shrinkage ratios.

(2) Denseness
   A sintering shrinkage ratio (D₁/D₀) in a Z-axis direction was determined from the thickness Do (in a Z-axis direction) of the substrate assembly before forming a constraining layer and the thickness D₁ of the sintered substrate assembly, and denseness was evaluated by the following standards.
   Good: D₁/D₀ was 60% or less, and
   Poor: D₁/D₀ was more than 60%.

(3) High-frequency characteristics
   The dielectric tangent *tan* δ of the sintered substrate assembly was measured at 2 GHz, and its high-frequency characteristics were evaluated by the following standards.
   Good: *tan* δ was 0.01 or less, and
   Poor: *tan* δ was more than 0.01.

(4) Conditions of external electrodes (platability)
   Using a commercially available electroless Ni-plating liquid and a commercially available electroless Au-plating liquid, a Ni plating having an average thickness of 5 µm and a Au plating having an average thickness of 0.4 µm were formed on each sample, from which the constraining layer was removed after sintering by ultrasonic washing. The plated external electrodes were observed by SEM to determine an area ratio of plating adhered to the external electrodes, from which the conditions of the external electrodes were evaluated by the following standards.
   Excellent: An area ratio of plating was 100%,
   Good: The area ratio of plating was less than 100% and 90% or more, and
   Poor: The area ratio of plating was less than 90%.

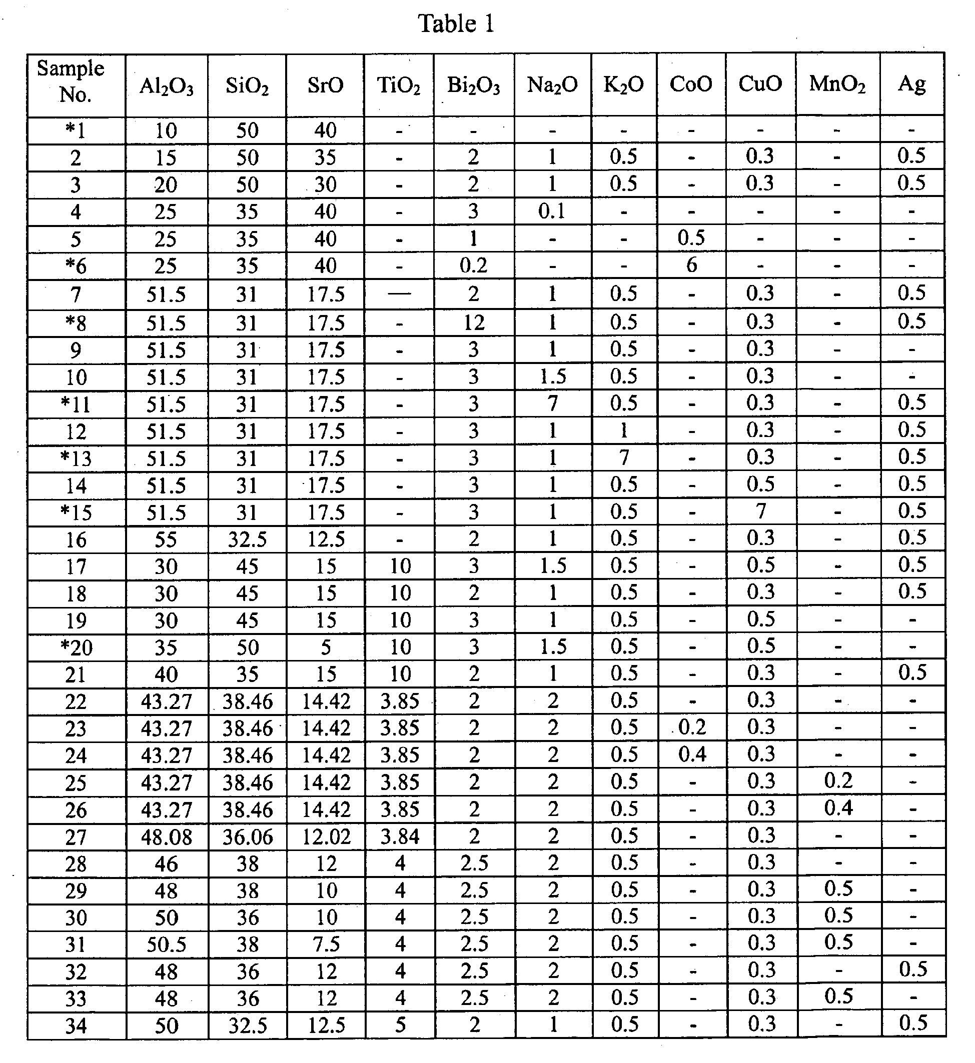

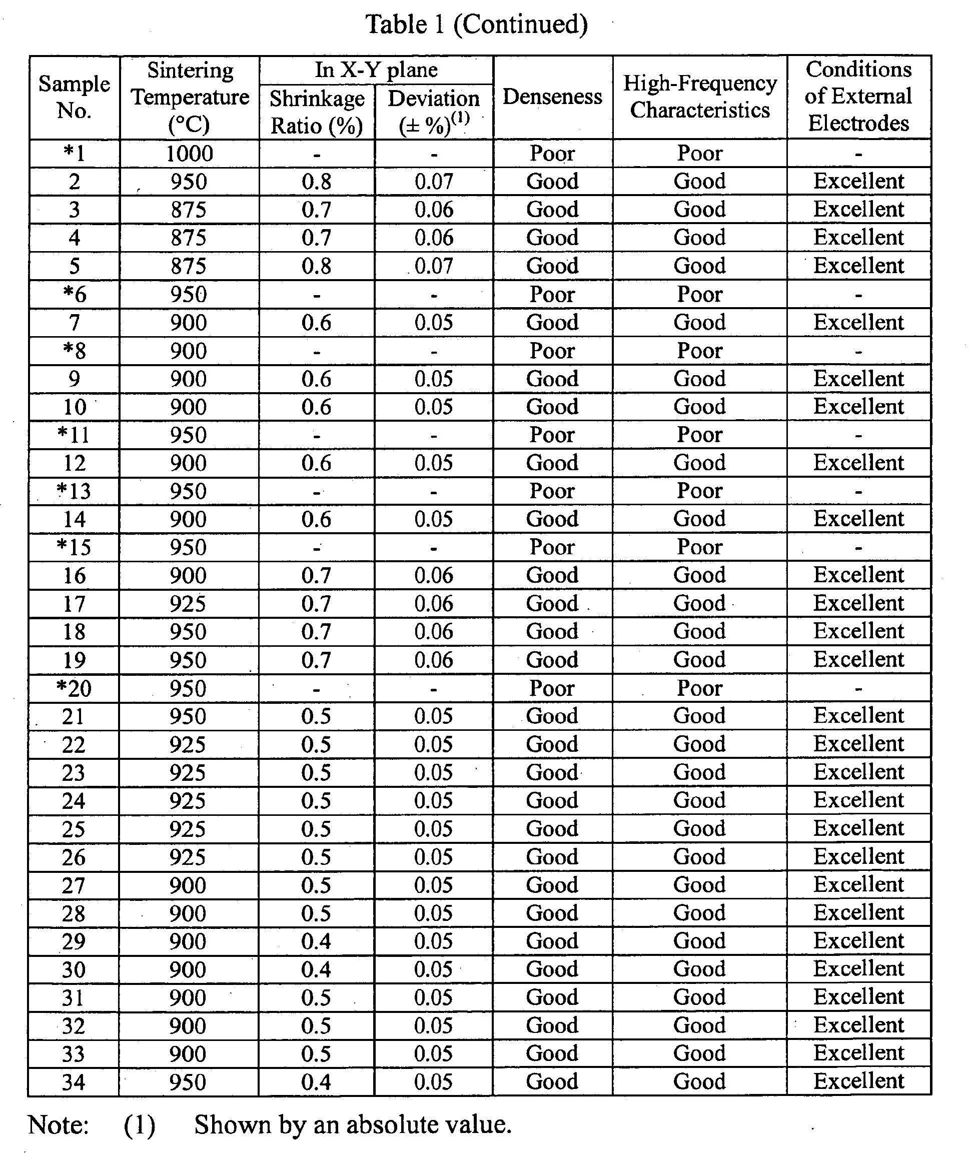

As is clear from Table 1, the multi-layer ceramic substrates of the present invention had sintering shrinkage ratios of 1% or less in an X-Y plane with their unevenness within ± 0.07%. Also, the multi-layer ceramic substrates of the present invention were good in denseness, high-frequency characteristics and the conditions of external electrodes.

### Example 2

Using Al₂O₃ powder having a purity of 99.9% and an average particle size of 0.5 µm, SiO₂ powder having a purity of 99.9% or more and an average particle size of 0.5 µm or less, SrCO₃ powder having a purity of 99.9% and an average particle size of 0.5 µm, and Bi₂O₃ powder, Na₂CO₃ powder, K₂CO₃ powder, CuO powder and MnO₂ powder each having a purity 99.9% and an average particle size of 0.5-5 µm, low-temperature-cofirable ceramic materials comprising Al, Si, Sr and Ti as main components and Bi, Na, K, Cu and Mn as auxiliary components, which corresponded to Sample 29 in Table 1, were produced as follows.
Main components:
Al: 48% by mass (calculated as Al₂O₃),
Si: 38% by mass (calculated as SiO₂),
Sr: 10% by mass (calculated as SrO), and
Ti: 4% by mass (calculated as TiO₂).
Auxiliary components (per 100 parts by mass of main components)
Bi: 2.5 parts by mass (calculated as Bi₂O₃),
Na: 2 parts by mass (calculated as Na₂O),
K: 0.5 parts by mass (calculated as K₂O),
Cu: 0.3 parts by mass (calculated as CuO), and
Mn: 0.5 parts by mass (calculated as MnO₂).

Each low-temperature-cofirable ceramic material was calcined in the same manner as in Example 1, and the resultant calcined body was finely pulverized to average particle sizes of about 1 µm and about 3 µm, respectively, to produce green substrate sheets.

Using alumina particles having an average particle size of 0.2-5 µm, a constraining layer having a total thickness of 30-550 µm was formed by a printing method and/or a green sheet method. Dividing grooves were formed in those other than Sample 44. All laminates of unsintered multi-layer ceramic substrates each having a constraining layer were sintered under the same conditions as in Example 1. Alumina particles of the constraining layers were removed from the sintered laminates by ultrasonic washing, to obtain substrate assemblies. With respect to each substrate assembly, a shrinkage ratio in an X-Y plane and its unevenness (deviation) and platability were evaluated in the same manner as in Example 1. Also, the amount of alumina particles remaining on external electrodes and their particle sizes, substrate warpage and the erosion of the external electrodes by soldering were evaluated by methods described below. The evaluation results are shown in Table 2.

(1) Amount of alumina remaining on external electrodes
   EDX analysis was conducted on Ag-Kα and Al-Kα lines of the external electrode surface (excluding impurities such as oxygen, etc.) by FE-SEM (Hitachi S-4500 having accelerating voltage of 15 kV), and the percentages by mass of Ag and Al were determined from their peak intensities by a standardless method. Because the percentage by mass of Al is proportional to the amount of alumina remaining on the electrode surface, the amount of the remaining alumina is expressed, as the percentage by mass of Al, by [Al/(Al + Ag)] x 100%.

(2) Number of alumina particles
   In the FE-SEM photograph (magnification: 3000-5000 times) of the external electrode surface, four lines having length corresponding to 20 µm were arbitrarily drawn in regions in which alumina particles existed, and among those crossing alumina particles as large as those used in the constraining layer, two lines crossing larger numbers of alumina particles were selected to determine the average number of alumina particles crossing the lines. Each sample was vapor-deposited with carbon to conduct EDX analysis at an accelerating voltage of 15 kV.

(3) Warpage
   In the course of measuring a shrinkage ratio, height difference in a Z-axis direction between diagonal lines of an arbitrarily selected chip was measured by a three-dimensional coordinates-measuring device as warpage. The permitted range of the warpage is about 40 µm.

(4) Erosion by soldering
   Each sample, from which the constraining layer was removed by ultrasonic waves, was immersed in a bath of Sn-_{3.5}Ag solder kept at 245°C for 1 minute, and the external electrodes were observed by an optical microscope. The erosion of the external electrodes of each sample by soldering was evaluated by an area ratio of metals (Ag + attached solder) on the external electrodes by the following standards.
   - Excellent:: An area ratio of metals on the external electrodes was 95% or more,
   - Good:: The area ratio of metals on the external electrodes was less than 95% and 85% or more, and
   - Poor:: The area ratio of metals on the external electrodes was less than 85%.

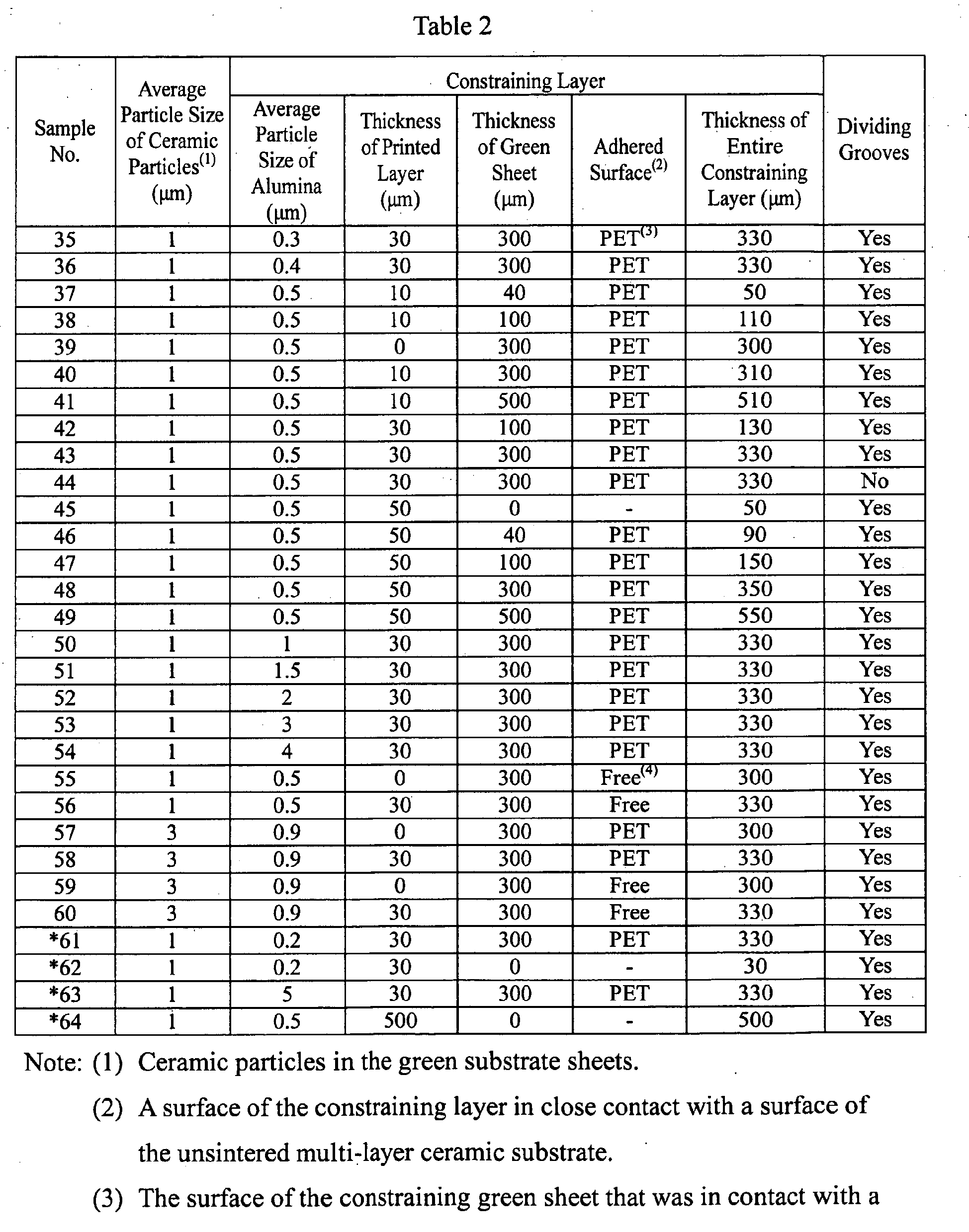

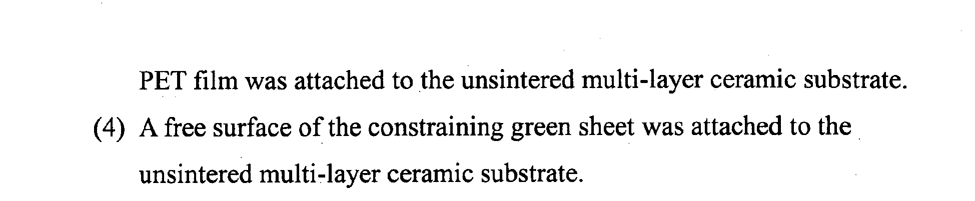

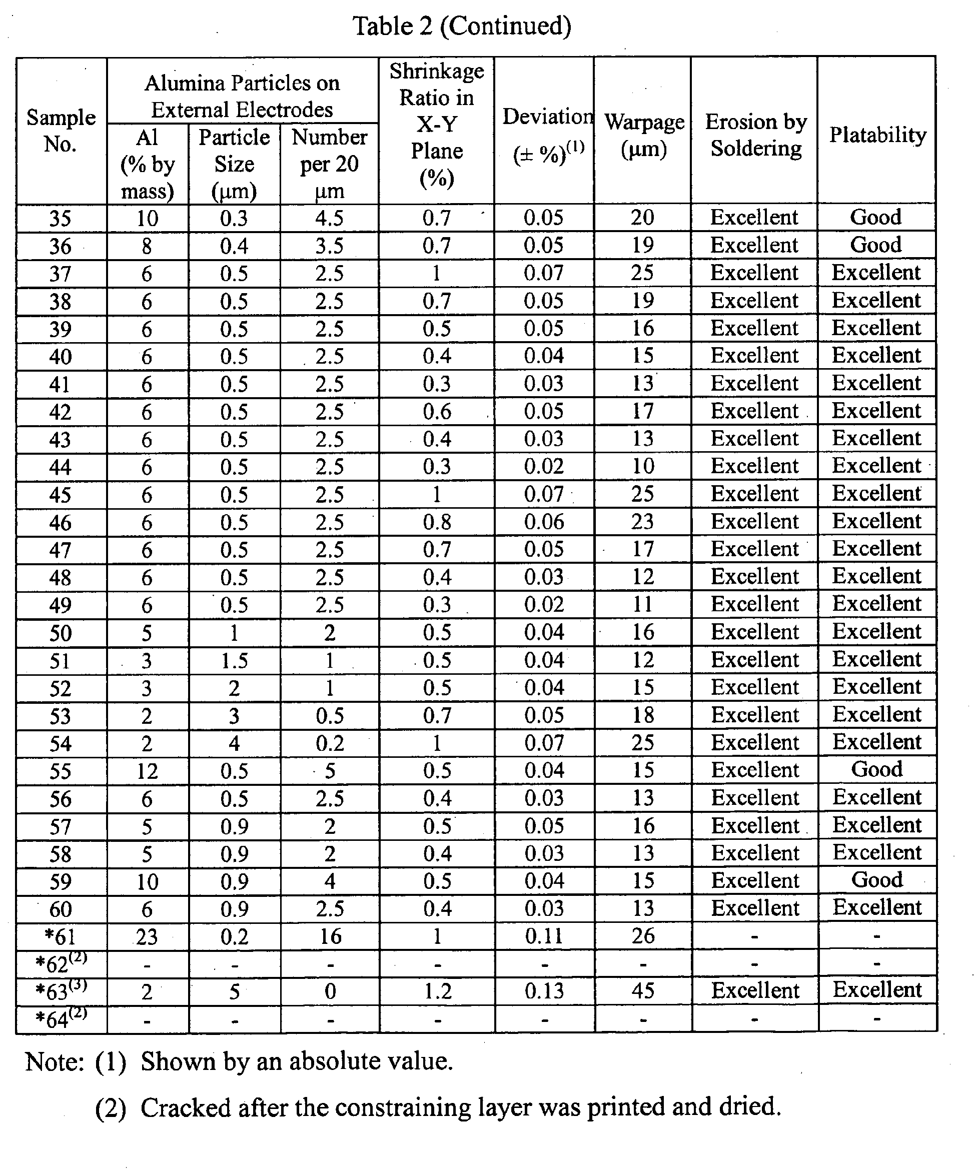

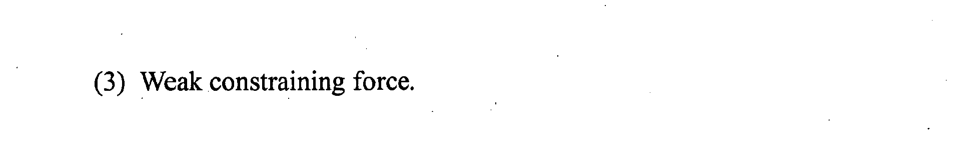

### Example 3

A mixed powder of glass powder and ceramic powder was used for green substrate sheets. Among starting material powders for low-temperature-cofirable ceramics having the same composition as in Example 2, a mixture of ceramic powders (oxide or carbonate) other than Al₂O₃ powder was charged into an alumina crucible, and heat-treated at 1400°C for 2 hours in an electric furnace to obtain a transparent glass block. This glass block was cut by a slicer, and then pulverized to an average particle size of about 1 µm and 3 µm, respectively, by a crasher and a ball mill. 52% by mass of the glass powder having an average particle size of about 1 µm, 48% by mass the alumina powder having an average particle size of about 1 µm, an organic binder, a plasticizer and a solvent were mixed in a ball mill, and the resultant slurry was formed into green substrate sheets. Similarly, a slurry comprising the glass powder having an average particle size of about 3 µm, alumina powder having an average particle size of about 3 µm, an organic binder, a plasticizer and a solvent was formed into green substrate sheets. In the same manner as in Example 1, the green substrate sheets were laminated and thermally press-bonded, and provided with dividing grooves, if necessary.

Using alumina particles having an average particle size of 0.2-5 µm, a constraining layer having a total thickness of 30-550 µm was formed by a printing method and/or a green sheet method. After sintering the resultant laminate, alumina particles in the constraining layer were removed by ultrasonic washing. Incidentally, other conditions than the above were the same as in Example 1.

Each of the resultant multi-layer ceramic substrates was evaluated under the same conditions as in Examples 1 and 2, with respect to a shrinkage ratio in an X-Y plane and its unevenness, substrate warpage, the erosion of the external electrodes by soldering, platability, and alumina remaining on the external electrodes. The evaluation results are shown in Table 3.

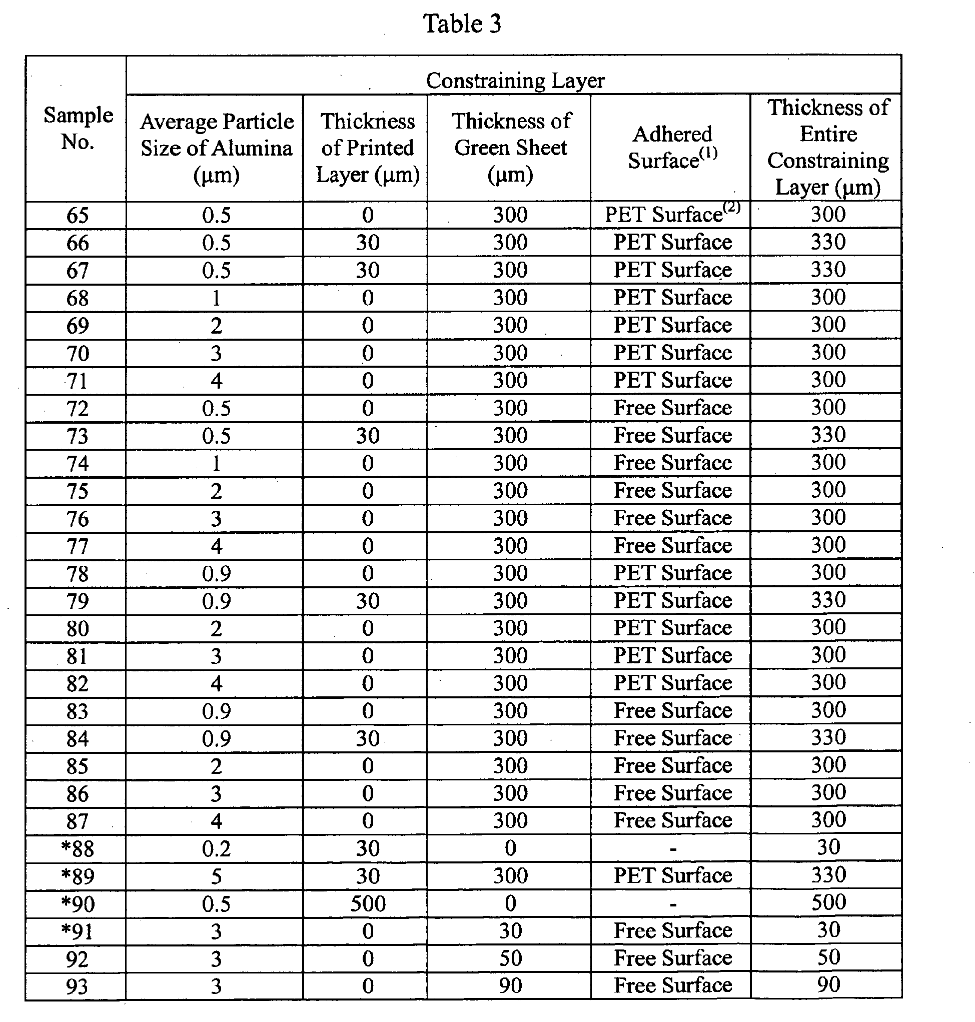

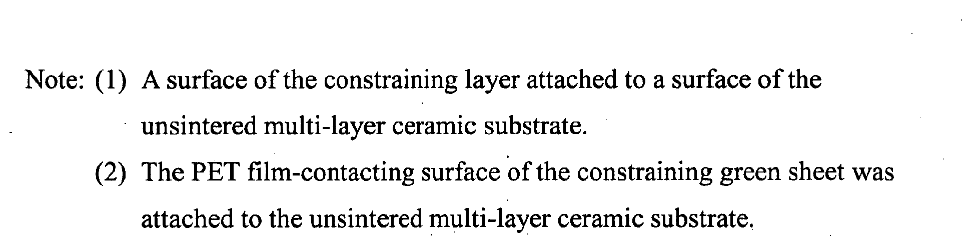

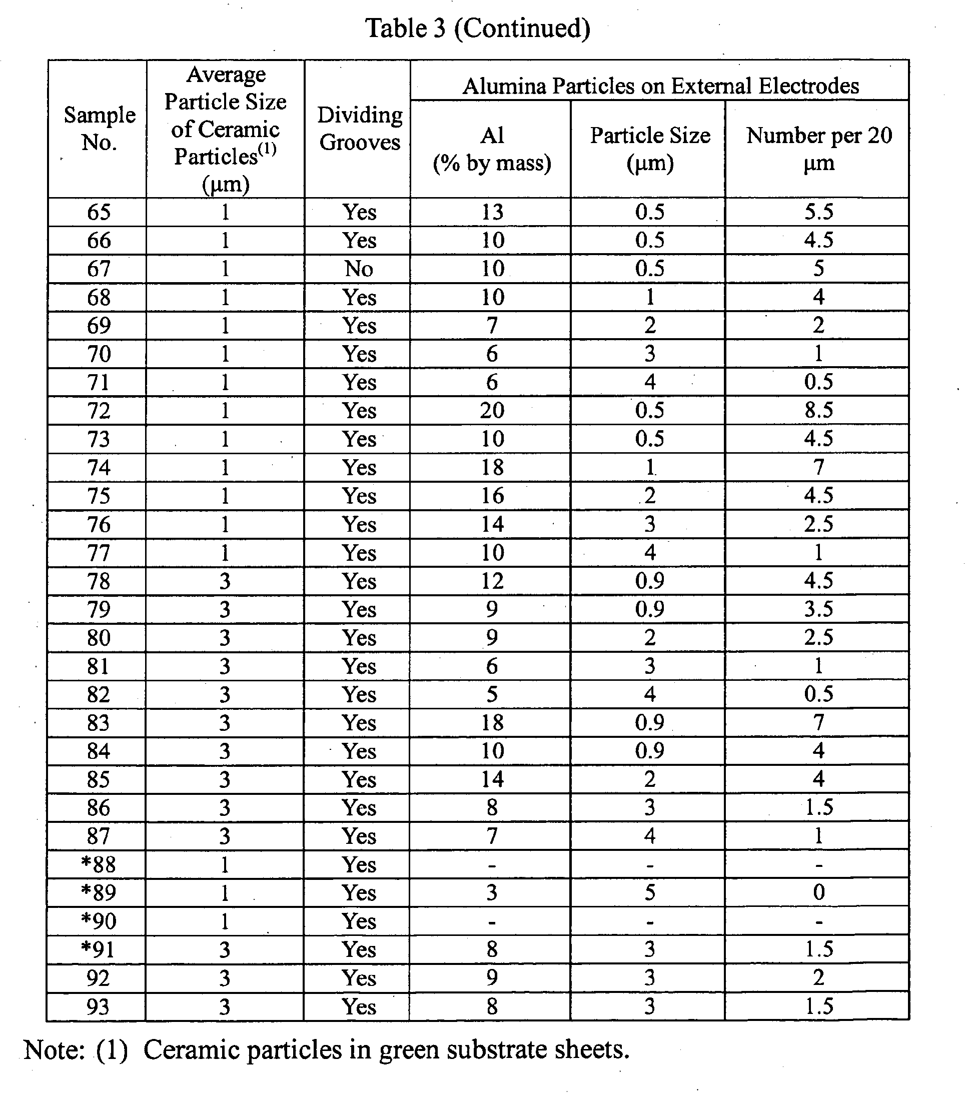

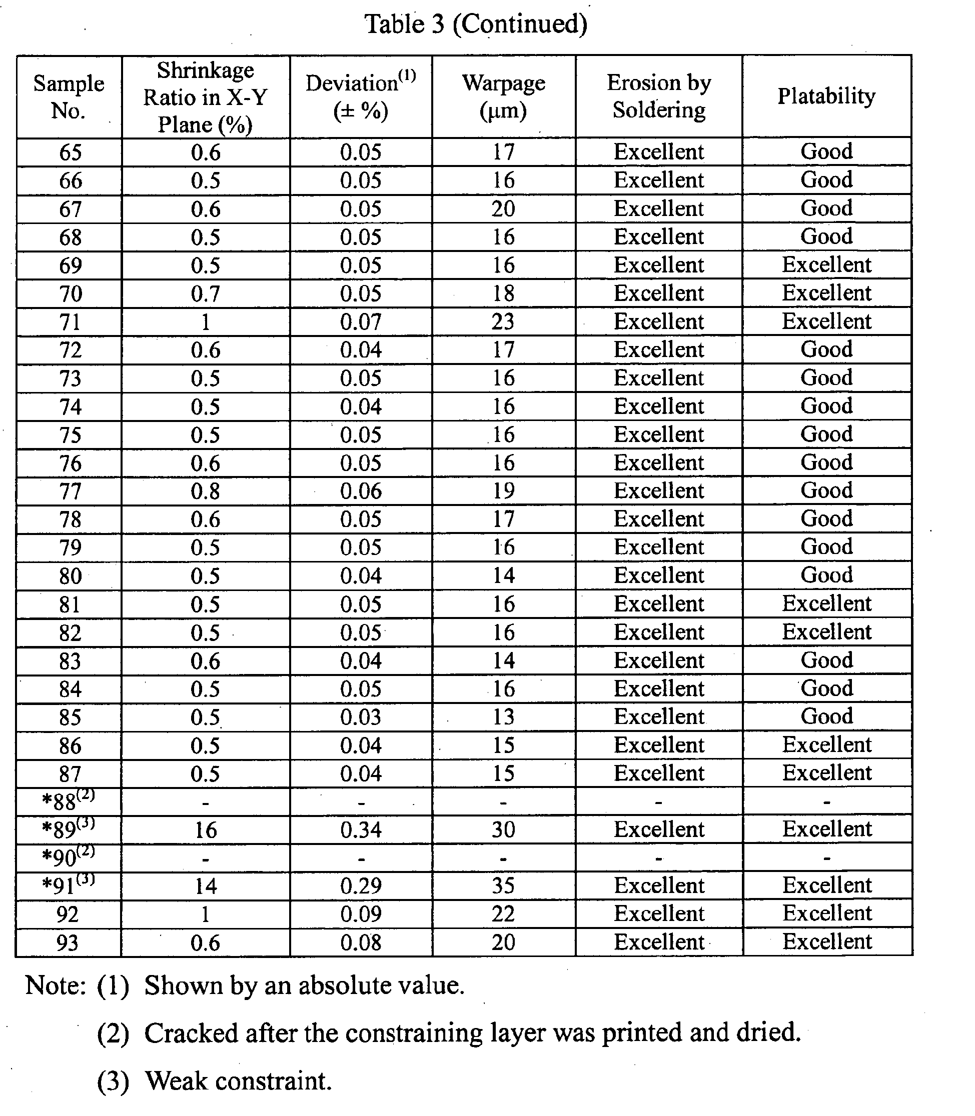

As is clear from Tables 2 and 3, in samples in which alumina particles forming the constraining layer had an average particle size of 0.3 µm or more, 0.3-4 times that of the ceramic particles forming the green substrate sheets, the multi-layer ceramic substrates had a sintering shrinkage ratio of 1% or less in an X-Y plane within ± 0.1% unevenness, which was in an acceptable range. On the other hand, when alumina particles having an average particle size outside the above range were used, a sufficient constraining force could not be obtained, thereby failing to constrain sintering shrinkage, and suffering cracking in the multi-layer ceramic substrate.

In the samples of the present invention, alumina particles remaining on the external electrode surface were 20% or less by mass, particularly 12% or less by mass (calculated as Al), causing no erosion by soldering, and providing good platability. The number of the remaining alumina particles was within 10 in the samples of the present invention. The comparison of green substrate sheets formed by powder obtained by pulverizing the calcined body with green substrate sheets formed by a mixture of powder obtained by pulverizing the calcined body and pulverized glass powder indicates that there were less remaining alumina in the former as a whole.

It was found that cracking occurred in a printed constraining layer, when its thickness was 50 µm or less or more than 500 µm. On the other hand, because a constraining layer formed by a green sheet can have a sufficient thickness, it was excellent in reducing a shrinkage ratio and warpage. It was found that with the surface of the constraining green sheet on the side of a PET film used as a constraining surface, the amount of alumina remaining on the electrodes was further reduced. Though better shrinkage ratio and warpage were obtained without dividing grooves, the method of the present invention provided good shrinkage ratio unevenness and warpage even when there were dividing grooves. In addition, no erosion by soldering was observed in any samples.

Though Samples 35, 36, 55 and 59 had slightly poor platability because of slight defective plating areas in the corners of the resultant electrodes, 90% or more of the electrode surface were plated, causing substantially no problems.

Even when at least one of magnesia particles, zirconia particles, titania particles and mullite particles were used as ceramic particles for the constraining layer in place of alumina particles, the same results were obtained. Also, even when sand blasting was conducted on the external electrodes at a sufficiently low impact force (for instance, 0.4 MPa) so as not to damage the external electrodes, the same results were obtained.

### Example 4

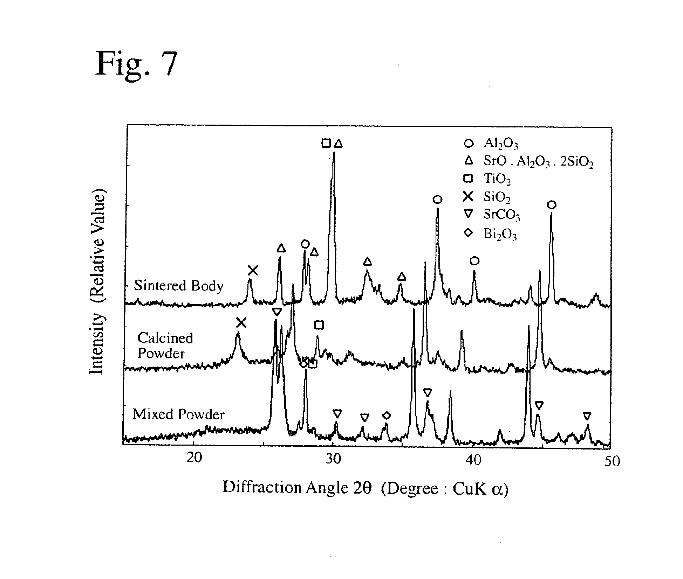

The crystal phases of the low-temperature co-firable ceramics used in Example 2 were analyzed by an X-ray diffraction method. With Cu as a target, its Kα line was used as a diffraction X-ray source. The X-ray powder diffraction patterns of the mixed powder, the calcined powder and the sintered body are shown in Fig. 7. In the case of the mixed powder, the crystal phases of materials were observed. In the case of the calcined powder, a glass phase was confirmed by a hallow pattern from 20° to 30°, in addition to the crystal phases of Al₂O₃, TiO₂ and SiO₂. It was confirmed in the sintered body that SrAl₂Si₂O₈ (strontium feldspar) was newly deposited. It is considered that such a structure has reduced influence on the electrodes, suitable for a no-shrinkage process.

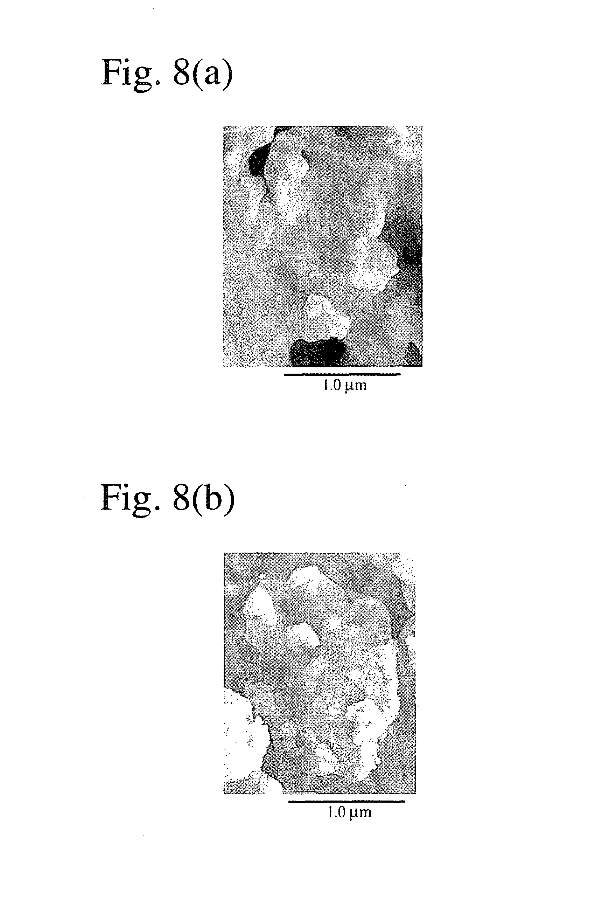

The scanning electron photomicrographs of the above calcined body and its pulverized powder are shown in Fig. 8. In the calcined body shown in Fig. 8(a), white particles are Al₂O₃, black portions are pores, and continuous phases are glass phases. Thus, the Al₂O₃ particles are partially or totally covered by the glass phase in the calcined body. In the powder obtained by pulverizing the calcined body shown in Fig. 8(b), too, the Al₂O₃ particles are partially or totally covered by the glass phase.

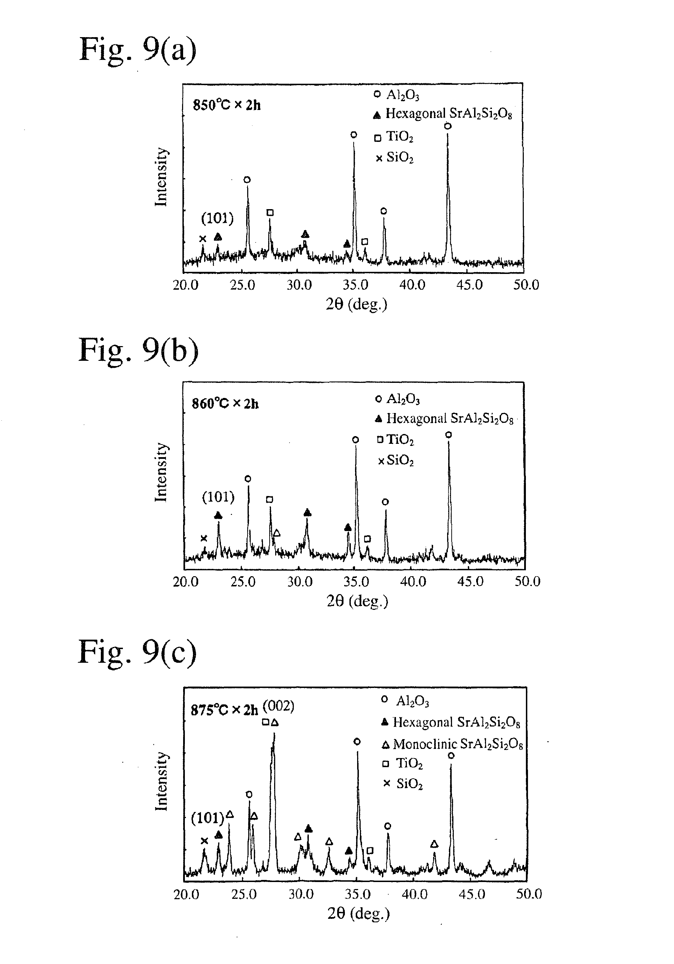

To try sintering at lower temperatures, a composition comprising 100 parts by mass of main components comprising 49% by mass, calculated as Al₂O₃, of Al, 34% by mass, calculated as SiO₂, of Si, 8.2% by mass, calculated as SrO, of Sr, and 3% by mass, calculated as TiO₂, of Ti, and as auxiliary components 2.5 parts by mass, calculated as Bi₂O₃, of Bi, 2 parts by mass, calculated as Na₂O, of Na, 0.5 parts by mass, calculated as K₂O, of K, 0.3 parts by mass, calculated as CuO, of Cu, and 0.5 parts by mass, calculated as Mn₃O₄, ofMn was calcined at 800°C to produce samples in the same manner as above. In this Example, sintering was conducted at 850°C, 860°C and 875°C, respectively, for 2 hours. These samples were subjected to X-ray diffraction measurement with a Cu-Kα line. Figs. 9(a)-(c) show the X-ray diffraction intensity patterns of samples sintered at 850°C, 860°C and 875°C, respectively. In the figure, white circles indicate an Al₂O₃ crystal, black triangles indicate a hexagonal SrAl₂Si₂O₈ crystal, and white squares indicate a monoclinic SrAl₂Si₂O₈ crystal.

In Figs. 9(a) and (b), the deposition of the hexagonal SrAl₂Si₂O₈ crystal together with the Al₂O₃ crystal, the TiO₂ crystal and the SiO₂ crystal was observed. As the sintering temperature was elevated, a monoclinic SrAl₂Si₂O₈ crystal was deposited, resulting in increase in diffraction peak intensity. The three-point bending test of these samples showed that the samples had higher bending strength in the order of (b), (a) and (c), the deposition of hexagonal SrAl₂Si₂O₈ being also higher in this order. The deposition of the hexagonal SrAl₂Si₂O₈ crystal is preferable from the aspect of strength, while the deposition of the monoclinic SrAl₂Si₂O₈ crystal should preferably be suppressed.

### Example 5

Al₂O₃ powder having a purity of 99.9% and an average particle size of 0.5 µm, SiO₂ powder having a purity of 99.9% or more and an average particle size of 0.5 µm or less, SrCO₃ powder having a purity of 99.9% and an average particle size of 0.5 µm, TiO₂ powder having a purity of 99.9% and an average particle size of 0.5 µm, and Bi₂O₃ powder, Na₂CO₃ powder, K₂CO₃ powder, CuO powder and MnO₂ powder each having a purity of 99.9% and an average particle size of 0.5-5 µm were mixed to a composition comprising 100 parts by mass of main components comprising 48% by mass, calculated as Al₂O₃, of Al, 38% by mass, calculated as SiO₂, of Si, 10% by mass, calculated as SrO, of Sr, and 4% by mass, calculated as TiO₂, of Ti, and as auxiliary components 2.5 parts by mass, calculated as Bi₂O₃, of Bi, 2 parts by mass, calculated as Na₂O, of Na, 0.5 parts by mass, calculated as K₂O, of K, 0.3 parts by mass, calculated as CuO, of Cu, and 0.5 parts by mass, calculated as MnO₂, of Mn, which corresponded to Sample 29 in Table 1. The resultant ceramic mixture was cast to green substrate sheets as thick as 15 µm, 50 µm, 100 µm and 200 µm, respectively, in the same manner as in Example 1. The calcining conditions were 800°C for 2 hours. Powder obtained by pulverizing the calcined body had an average particle size of about 1 µm.

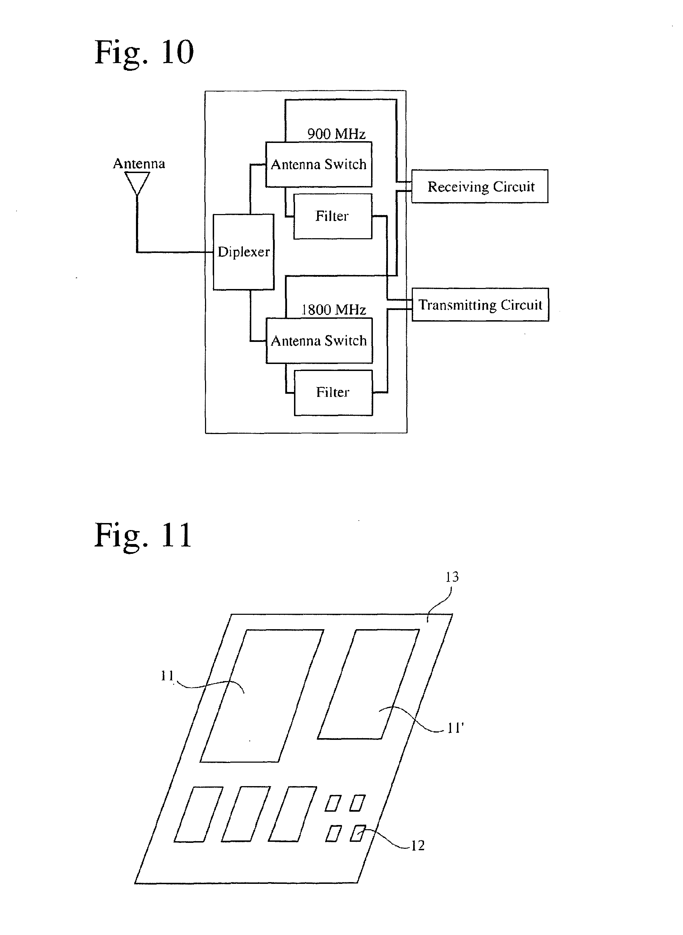

Each green substrate sheet was cut to a substantially square shape of 180 mm each, via-holes were formed in each sheet having a predetermined thickness, and high-frequency circuit patterns for filters, antenna switches and diplexers were printed using an Ag-based electrode material. The circuit block is shown in Fig. 10. Nine sheets each having a predetermined thickness, on which circuit patterns were printed, were laminated, press-bonded, printed with external electrodes, and provided with dividing grooves on upper and lower surfaces, to produce an integral substrate assembly dividable to pluralities of multi-layer ceramic substrate chips. Each multi-layer ceramic substrate chip had a substantially square shape of 8 mm x 8 mm as thick as about 1.3 mm before sintering. The substrate assembly of about 180 mm x 180 mm had 400 multi-layer ceramic substrate chips in a lattice pattern via the dividing grooves.

Sample 51 selected from Example 2 was printed with a constraining alumina layer on both upper and lower surfaces, sintered, and stripped of the constraining layer, plated, washed and dried in the same manner as in Example 2.

Using a metal mask, a Pb-free solder paste was printed on predetermined portions of the substrate assembly on an upper surface. After chip parts were mounted onto the soldered portions, solder reflow was conducted in a reflow furnace. After semiconductor parts were mounted, connection and sealing were conducted. Finally, the substrate assembly was divided to each multi-layer ceramic substrate along the dividing grooves. The substrate assembly, which was in a substantially square shape of 180 mm each, had an in-plane shrinkage ratio of 0.5% or less with unevenness within ± 0.05%, and as small height difference as 50 µm in a thickness direction (Z-axis direction). Accordingly, no troubles occurred at all in the steps of printing a solder paste and mounting parts on 400 multi-layer ceramic substrate chips. On the other hand, because the substrates had lowered dimensional accuracy due to sintering shrinkage in the conventional method, only about 250 multi-layer ceramic substrate chips were obtained as products free from troubles in soldering and the mounting of parts.

## Claims

1. A multi-layer ceramic substrate obtained by laminating low-temperature-sinterable green substrate sheets comprising a ceramic material, forming external electrodes at least on an upper surface of the resultant unsintered multi-layer ceramic substrate, bonding a constraining layer comprising as main components inorganic particles which are not sintered at the sintering temperature of said unsintered multi-layer ceramic substrate to upper and/or lower surfaces of said unsintered multi-layer ceramic substrate having said external electrodes to form an integral laminate, sintering said integral laminate, and then removing said constraining layer, wherein said multi-layer ceramic substrate has an in-plane shrinkage ratio of 1% or less within 0.1 % unevenness, and wherein said inorganic particles remaining on said external electrodes are 20% or less by mass as a percentage of one or more metals constituting said inorganic particles to the total amount of one or more metals constituting said external electrodes and one or more metals constituting said inorganic particles.

2. The multi-layer ceramic substrate according to claim 1, wherein said ceramic material comprises as main components 10-60% by mass, calculated as Al₂O₃, of Al, 25-60% by mass, calculated as SiO₂, of Si, 7.5-50% by mass, calculated as SrO, of Sr, and 0-20% by mass, calculated as TiO₂, of Ti in the form of oxides, the total amount of Al₂O₃, SiO₂, SrO and TiO₂ being 100% by mass, said ceramic material being in the form of powder obtained by pulverization after calcining at 700°C to 850°C.

3. The multi-layer ceramic substrate according to claim 2, wherein said ceramic material comprises as an auxiliary component 0.1-10 parts by mass, calculated as Bi₂O₃, of Bi per 100 parts by mass of said main components.

4. The multi-layer ceramic substrate according to claim 3, wherein said auxiliary component comprises at least one selected from the group consisting of 0.1-10 parts by mass, calculated as Bi₂O₃, of Bi, 0.1-5 parts by mass, calculated as Na₂O, of Na, 0.1-5 parts by mass, calculated as K₂O, of K, and 0.1-5 parts by mass, calculated as CoO, of Co, and at least one selected from the group consisting of 0.01-5 parts by mass, calculated as CuO, of Cu, 0.01-5 parts by mass, calculated as MnO₂; of Mn, and 0.01-5 parts by mass of Ag, per 100 parts by mass of said main components.

5. A multi-layer ceramic substrate obtained by laminating low-temperature-sinterable green substrate sheets containing a ceramic material, forming external electrodes at least on an upper surface of the resultant unsintered multi-layer ceramic substrate, bonding a constraining layer comprising as main components inorganic particles which are not sintered at the sintering temperature of said unsintered multi-layer ceramic substrate to upper and/or lower surfaces of said unsintered multi-layer ceramic substrate having said external electrodes to form an integral laminate, sintering said integral laminate, and then removing said constraining layer, wherein said multi-layer ceramic substrate has a structure comprising a feldspar crystal based on strontium feldspar and an alumina crystal.

6. The multi-layer ceramic substrate according to claim 5, wherein at least part of said strontium feldspar is hexagonal.

7. The multi-layer ceramic substrate according to claim 5 or 6, wherein it has an in-plane shrinkage ratio of 1% or less with 0.1 % or less of unevenness, and wherein said inorganic particles remaining on said external electrodes are 20% or less by mass as a percentage of one or more metals constituting said inorganic particles to the total of one or more metals constituting said external electrodes and one or more metals constituting said inorganic particles.

8. A method for producing a multi-layer ceramic substrate comprising the steps of (a) preparing low-temperature-sinterable green substrate sheets from a slurry containing ceramic material powder and an organic binder, (b) laminating said green substrate sheets after forming electrodes thereon, to form an unsintered multi-layer ceramic substrate, (c) bonding a constraining layer comprising inorganic particles which are not sintered at the sintering temperature of said unsintered multi-layer ceramic substrate and an organic binder to upper and/or lower surfaces of said unsintered multi-layer ceramic substrate having said external electrodes, to form an integral laminate, (d) sintering said integral laminate, and (e) removing said constraining layer from a surface of the sintered laminate, wherein said inorganic particles have an average particle size of 0.3 µm or more, 0.3-4 times the average particle size of said ceramic material powder.

9. The method for producing a multi-layer ceramic substrate according to claim 8, wherein a constraining green sheet comprising inorganic particles and an organic binder is formed as said constraining layer on a carrier film, and wherein a carrier film-contacting surface of said constraining green sheet is bonded to upper and/or lower surfaces of said unsintered multi-layer ceramic substrate having said external electrodes.

10. The method for producing a multi-layer ceramic substrate according to claim 8 or 9, wherein said constraining layer is as thick as 50 µm or more.

11. The method for producing a multi-layer ceramic substrate according to claim 8 or 9, wherein a first constraining layer as thick as 10 µm or more is formed by coating, and a constraining green sheet is overlapped thereon as a second constraining layer, thereby forming a constraining layer having an overall thickness of 50 µm or more.

12. The method for producing a multi-layer ceramic substrate according to any one of claims 8-11, wherein said unsintered multi-layer ceramic substrate is produced in the form of a substrate assembly which can be divided to pluralities of substrate chips along dividing grooves, and wherein said constraining layer is formed on upper and/or lower surfaces of said substrate assembly having external electrodes.

13. A method for producing a multi-layer ceramic substrate comprising the steps of (a) finely pulverizing a ceramic material comprising 10-60% by mass, calculated as Al₂O₃, of Al, 25-60% by mass, calculated as SiO₂, of Si, 7.5-50% by mass, calculated as SrO, of Sr, and 0-20% by mass, calculated as TiO₂, of Ti as main components, the total amount of Al₂O₃, SiO₂, SrO and TiO₂ being 100% by mass, which is calcined at 700°C to 850°C, (b) preparing low-temperature-sinterable green substrate sheets from a slurry containing the resultant fine powder of the calcined body and an organic binder, (c) laminating said green substrate sheets after forming electrodes thereon, to form an unsintered multi-layer ceramic substrate, (d) bonding a constraining layer comprising inorganic particles which are not sintered at the sintering temperature of said unsintered multi-layer ceramic substrate, and an organic binder, to upper and/or lower surfaces of said unsintered multi-layer ceramic substrate having said external electrodes, to form an integral laminate, (e) sintering said integral laminate at 800°C to 1000°C, and (f) removing said constraining layer from said laminate.

14. The method for producing a multi-layer ceramic substrate according to claim 13, wherein said green substrate sheets comprise as auxiliary components at least one selected from the group consisting of 0.1-10 parts by mass, calculated as Bi₂O₃, of Bi, 0.1-5 parts by mass, calculated as Na₂O, of Na, 0.1-5 parts by mass, calculated as K₂O, of K, and 0.1-5 parts by mass, calculated as CoO, of Co, and at least one selected from the group consisting of 0.01-5 parts by mass, calculated as CuO, of Cu, 0.01-5 parts by mass, calculated as MnO₂, of Mn, and 0.01-5 parts by mass ofAg, per 100 parts by mass of said main components.

15. The method for producing a multi-layer ceramic substrate according to claim 13 or 14, wherein the average particle size of said inorganic particles is 0.3 µm or more, 0.3-4 times that of fine powder of said calcined ceramic material.

16. The method for producing a multi-layer ceramic substrate according to any one of claims 13-15, wherein a constraining green sheet comprising inorganic particles and an organic binder is formed as said constraining layer on a carrier film, and a carrier film-contacting surface of said constraining green sheet is bonded to upper and/or lower surfaces of said unsintered multi-layer ceramic substrate having said external electrodes.

17. The method for producing a multi-layer ceramic substrate according to any one of claims 13-16 wherein said constraining layer is as thick as 50 µm or more.

18. The method for producing a multi-layer ceramic substrate according to any one of claims 13-16, wherein a first constraining layer as thick as 10 µm or more is formed by coating, and a constraining green sheet is overlapped thereon as a second constraining layer, thereby forming a constraining layer having an overall thickness of 50 µm or more.

19. The method for producing a multi-layer ceramic substrate according to any one of claims 13-18, wherein said unsintered multi-layer ceramic substrate is produced in the form of a substrate assembly which can be divided to pluralities of substrate chips along dividing grooves, and said constraining layer is disposed on upper and/or lower surfaces of said substrate assembly having external electrodes.

20. An electronic device comprising the multi-layer ceramic substrate recited in any one of claims 1-7, which is mounted onto a circuit board.

21. An electronic device comprising the multi-layer ceramic substrate produced by the method recited in any one of claims 8-19, which is mounted onto a circuit board.
